# EUROPEAN PATENT APPLICATION

(11) **EP 4 808 286 A1**
(43) Date of publication of application: **16.09.2026**
(21) Application number: 24888838.0
(22) Date of filing: 11.11.2024
(51) Int. Cl.: H05K 1/02, H01L 23/12, H01L 23/15, H05K 1/03, H05K 3/46

(54) **THROUGH-ELECTRODE SUBSTRATE INTERMEDIATE, THROUGH-ELECTRODE SUBSTRATE, THROUGH-ELECTRODE SUBSTRATE WITH ELEMENT, AND SEMICONDUCTOR DEVICE**

(30) Priority: 10.11.2023 JP 2023192209; 07.12.2023 JP 2023206787
(71) Applicant: Dai Nippon Printing Co., Ltd., Tokyo 162-8001 (JP)
(72) Inventor: KURAMOCHI, Satoru, Tokyo 162-8001 (JP); MIYOSHI, Toru, Tokyo 162-8001 (JP)
(74) Representative: Müller-Boré & Partner Patentanwälte PartG mbB
(86) International application number: PCT/JP2024/040007
(87) International publication number: WO 2025/100547

(57) **Abstract**

The present disclosure provides a through electrode substrate intermediate comprising: a glass substrate including a first surface and a second surface facing the first surface, and including a through hole; a through electrode disposed in the through hole of the glass substrate; an elastic insulating layer disposed on a first surface side of the glass substrate; a via passing through the elastic insulating layer, and electrically connected to the through electrode; a pad portion for a via disposed on a surface of the elastic insulating layer that is opposite side to the glass substrate, and electrically connected to the via; and a pad portion for connecting a wiring board disposed on a surface of the elastic insulating layer that is opposite side to the glass substrate, and to be electrically connected to a wiring board, wherein the elastic insulating layer has a convexoconcave shape, including a plurality of convex portions and a plurality of concave portions, on a surface that is on a side of the pad portion for a via and the pad portion for connecting a wiring board.

## Description

### Technical Field

The present disclosure relates to a through electrode substrate intermediate, a through electrode substrate, a through electrode substrate provided with an element, and a semiconductor device.

### Background Art

Various technologies related to interposers that relay between a motherboard and a chip with different terminal pitches have been conventionally proposed (see Patent Document 1).

### Citation List

### Patent Document

Patent Document 1: Japanese Patent Application Laid-Open (JP-A) No. 2021-73684

### Summary of Disclosure

### Technical Problem

It is known that a through electrode substrate with a through electrode is used as an interposer. Also, as for the types of the interposers, for example, silicon interposers, organic interposers, and glass interposers are known. In particular, organic interposers and glass interposers are attracting attention to reduce costs.

However, the thermal expansion coefficients of organic materials such as glass epoxy used for organic interposers differ significantly from those of semiconductor materials such as silicon used for the elements. Therefore, when the materials are heated during the production process of semiconductor devices, or when semiconductor devices are used in high-temperature environments, the difference in thermal expansion coefficients between organic materials and semiconductor materials causes stress at the joining portions, pad portions, and wiring that electrically connect the organic interposer and the element, leading to problems such as cracks and disconnections.

Meanwhile, in glass interposers, the difference between the thermal expansion coefficient of the glass substrate used for the glass interposer and the thermal expansion coefficient of the semiconductor material can be reduced.

However, the thermal expansion coefficient of the glass substrates differs significantly from that of the glass epoxy substrates commonly used in motherboards. Therefore, when the materials are heated during the production process of semiconductor devices, or when semiconductor devices are used in high-temperature environments, the difference in thermal expansion coefficients between the glass substrate of the glass interposer and the glass epoxy substrate of the motherboard causes stress at the joining portions, pad portions, and wiring that electrically connect the glass interposer and the motherboard, leading to cracks and disconnections.

The present disclosure has been made in view of the above circumstances, and an object of the present disclosure is to provide a through electrode substrate intermediate, a through electrode substrate, through electrode substrate provided with an element and a semiconductor device capable of suppressing disconnections.

### Solution to Problem

One embodiment of the present disclosure provides a through electrode substrate intermediate comprising: a glass substrate including a first surface and a second surface facing the first surface, and including a through hole; a through electrode disposed in the through hole of the glass substrate; an elastic insulating layer disposed on a first surface side of the glass substrate; a via passing through the elastic insulating layer, and electrically connected to the through electrode; a pad portion for a via disposed on a surface of the elastic insulating layer that is opposite side to the glass substrate, and electrically connected to the via; and a pad portion for connecting a wiring board disposed on a surface of the elastic insulating layer that is opposite side to the glass substrate, and to be electrically connected to a wiring board, wherein the elastic insulating layer has a convexoconcave shape, including a plurality of convex portions and a plurality of concave portions, on a surface that is on a side of the pad portion for a via and the pad portion for connecting a wiring board.

Another embodiment of the present disclosure provides a through electrode substrate comprising: the through electrode substrate intermediate described above; and a bellows wiring layer disposed on an elastic insulating layer side surface of the through electrode substrate intermediate, including a bellows-shaped portion including a plurality of mountain portions and a plurality of valley portions, and electrically connecting the pad portion for a via and the pad portion for connecting a wiring board.

Another embodiment of the present disclosure provides a through electrode substrate provided with an element comprising: the through electrode substrate described above; and an element mounted on the through electrode substrate.

Another embodiment of the present disclosure provides a semiconductor device comprising: the through electrode substrate provided with an element described above; and a wiring board electrically connected to the pad portion for connecting a wiring board of the through electrode substrate.

Another embodiment of the present disclosure provides a through electrode substrate comprising: a glass substrate including a first surface and a second surface facing the first surface, and including a first through hole; a through electrode disposed in the first through hole of the glass substrate; a covered insulating layer disposed on a first surface side of the glass substrate so as to cover at least a boundary between the through electrode and the glass substrate, and including a second through hole connected to the first through hole; a first via disposed in the second through hole of the covered insulating layer, and electrically connected to the through electrode; an elastic insulating layer disposed on a surface of the covered insulating layer that is opposite to the glass substrate, and including a third through hole; a second via disposed in the third through hole of the elastic insulating layer, and electrically connected to the first via; and a pad portion for connecting a wiring board disposed on a surface of the elastic insulating layer that is opposite side to the covered insulating layer, electrically connected to the second via, and to be electrically connected to a wiring board.

Another embodiment of the present disclosure provides a through electrode substrate provided with an element comprising: the through electrode substrate described above; and an element mounted on the through electrode substrate.

Another embodiment of the present disclosure provides a semiconductor device comprising: the through electrode substrate provided with an element described above; and a wiring board electrically connected to the pad portion for connecting a wiring board of the through electrode substrate.

### Advantageous Effects of Disclosure

The present disclosure exhibits effects that disconnections can be suppressed.

### Brief Description of Drawings

[FIGS. 1] are a schematic plan view and a cross-sectional view illustrating an example of a through electrode substrate intermediate in the first embodiment in the present disclosure.
[FIGS. 2] are a schematic plan view and a cross-sectional view illustrating an example of a through electrode substrate in the first embodiment in the present disclosure.
[FIG. 3] is a schematic cross-sectional view illustrating an example of a through electrode substrate provided with an element in the first embodiment in the present disclosure.
[FIG. 4] is a schematic cross-sectional view illustrating an example of a semiconductor device in the first embodiment in the present disclosure.
[FIGS. 5] are a schematic plan view and a cross-sectional view illustrating an example of a through electrode substrate intermediate in the first embodiment in the present disclosure.
[FIGS. 6] are a schematic plan view and a cross-sectional view illustrating an example of a through electrode substrate in the first embodiment in the present disclosure.
[FIG. 7] is a schematic cross-sectional view illustrating an example of a through electrode substrate provided with an element in the first embodiment in the present disclosure.
[FIG. 8] is a schematic cross-sectional view illustrating an example of a semiconductor device in the first embodiment in the present disclosure.
[FIG. 9] is a schematic cross-sectional view illustrating an example of an elastic insulating layer of a through electrode substrate intermediate in the present disclosure.
[FIG. 10] is a schematic cross-sectional view illustrating an example of a through electrode substrate intermediate in the first embodiment in the present disclosure.
[FIG. 11] is a schematic plan view illustrating an example of a through electrode substrate intermediate in the first embodiment in the present disclosure.
[FIGS. 12] are schematic cross-sectional views illustrating an example of a cross-sectional view shape of a through hole of a glass substrate of a through electrode substrate intermediate in the present disclosure.
[FIGS. 13] are schematic cross-sectional views explaining the gaps and bulges that occur in the through electrode substrate.
[FIG. 14] is a schematic cross-sectional view illustrating an example of a through electrode substrate intermediate in the first embodiment in the present disclosure.
[FIGS. 15] are schematic cross-sectional views illustrating an example of a glass substrate and a covered insulating layer of a through electrode substrate intermediate in the first embodiment in the present disclosure.
[FIG. 16] is a schematic cross-sectional view illustrating an example of a through electrode substrate intermediate in the first embodiment in the present disclosure.
[FIG. 17] is a schematic cross-sectional view illustrating an example of a through electrode substrate intermediate in the first embodiment in the present disclosure.
[FIG. 18] is a schematic cross-sectional view illustrating an example of a through electrode substrate intermediate in the first embodiment in the present disclosure.
[FIG. 19] is a schematic cross-sectional view illustrating an example of an elastic insulating layer and a bellows wiring layer of a through electrode substrate in the first embodiment in the present disclosure.
[FIG. 20] is a schematic plan view illustrating an example of a through electrode substrate intermediate in the first embodiment in the present disclosure.
[FIG. 21] is a schematic cross-sectional view illustrating an example of a through electrode substrate in the first embodiment in the present disclosure.
[FIGS. 22] are a schematic plan view and a cross-sectional view illustrating an example of a through electrode substrate in the first embodiment in the present disclosure.
[FIG. 23] is a schematic cross-sectional view illustrating an example of a through electrode substrate in the second embodiment in the present disclosure.
[FIG. 24] is a schematic cross-sectional view illustrating an example of a through electrode substrate provided with an element in the second embodiment in the present disclosure.
[FIG. 25] is a schematic cross-sectional view illustrating an example of a semiconductor device in the second embodiment in the present disclosure.
[FIG. 26] is a schematic cross-sectional view illustrating an example of a through electrode substrate in the second embodiment in the present disclosure.
[FIG. 27] is a schematic cross-sectional view illustrating an example of a through electrode substrate in the second embodiment in the present disclosure.
[FIG. 28] is a schematic cross-sectional view illustrating an example of a through electrode substrate in the second embodiment in the present disclosure.
[FIG. 29] is a schematic cross-sectional view illustrating an example of an elastic insulating layer of a through electrode substrate in the present disclosure.
[FIG. 30] is a schematic cross-sectional view illustrating an example of a through electrode substrate in the second embodiment in the present disclosure.
[FIG. 31] is a schematic cross-sectional view illustrating an example of a through electrode substrate in the second embodiment in the present disclosure.
[FIGS. 32] are schematic cross-sectional views illustrating an example of a covered insulating layer of a through electrode substrate in the second embodiment in the present disclosure.
[FIG. 33] is a schematic cross-sectional view illustrating an example of a through electrode substrate in the second embodiment in the present disclosure.
[FIG. 34] is a schematic cross-sectional view illustrating an example of a through electrode substrate in the second embodiment in the present disclosure.
[FIG. 35] is a schematic cross-sectional view illustrating an example of a through electrode substrate in the second embodiment in the present disclosure.

### Description of Embodiments

Embodiments in the present disclosure are hereinafter explained with reference to, for example, drawings. However, the present disclosure is enforceable in a variety of different forms, and thus should not be taken as is limited to the contents described in the embodiments exemplified as below. Also, the drawings may show the features of the present disclosure such as width, thickness, and shape of each part schematically comparing to the actual form in order to explain the present disclosure more clearly in some cases; however, it is merely an example, and thus does not limit the interpretation of the present disclosure. Also, in the present descriptions and each drawing, for the factor same as that described in the figure already explained, the same reference sign is indicated and the detailed explanation thereof may be omitted.

In the present descriptions, on the occasion of expressing an aspect wherein some member is disposed on the other member, when described as merely "on" or "below", unless otherwise stated, it includes both of the following cases: a case wherein some member is disposed directly on or directly below the other member so as to be in contact with the other member, and a case wherein some member is disposed on the upper side or the lower side of the other member via yet another member. Also, in the present descriptions, on the occasion of expressing an aspect wherein some member is disposed on the surface of the other member, when described as merely "on the surface side" or "on the surface", unless otherwise stated, it includes both of the following cases: a case wherein some member is disposed directly on or directly below the other member so as to be in contact with the other member, and a case wherein some member is disposed on the upper side or the lower side of the other member via yet another member.

The present disclosure includes two embodiments. Each embodiment is hereinafter described.

### I. First embodiment

First of all, the details of the through electrode substrate intermediate, through electrode substrate, through electrode substrate provided with an element, and semiconductor device in the first embodiment in the present disclosure are described.

### A. Through electrode substrate intermediate

The through electrode substrate intermediate in the present embodiment comprises: a glass substrate including a first surface and a second surface facing the first surface, and including a through hole; a through electrode disposed in the through hole of the glass substrate; an elastic insulating layer disposed on a first surface side of the glass substrate; a via passing through the elastic insulating layer, and electrically connected to the through electrode; a pad portion for a via disposed on a surface of the elastic insulating layer that is opposite side to the glass substrate, and electrically connected to the via; and a pad portion for connecting a wiring board disposed on a surface of the elastic insulating layer that is opposite side to the glass substrate, and to be electrically connected to a wiring board, wherein the elastic insulating layer has a convexoconcave shape, including a plurality of convex portions and a plurality of concave portions, on a surface that is on a side of the pad portion for a via and the pad portion for connecting a wiring board.

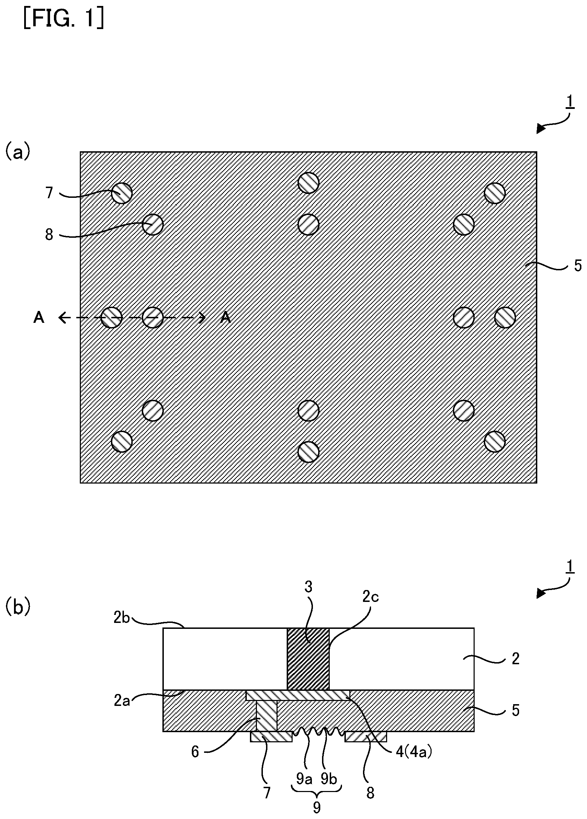

FIG. 1(a) and FIG. 1(b) are a schematic plan view and a cross-sectional view showing an example of a through electrode substrate intermediate in the present embodiment, and FIG. 1(b) is an A-A line cross-sectional view of FIG. 1(a). As shown in FIG. 1(a) and FIG. 1(b), the through electrode substrate intermediate 1 comprises: a glass substrate 2 including a first surface 2a and a second surface 2b facing the first surface 2a, and including a through hole 2c; a through electrode 3 disposed in the through hole 2c of the glass substrate 2; a first wiring layer 4 disposed on the first surface 2a side of the glass substrate 2, electrically connected to the through electrode 3, and including a conductive layer 4a; an elastic insulating layer 5 disposed on the surface of the first wiring layer 4 that is opposite to the glass substrate 2; a via 6 passing through the elastic insulating layer 5, and electrically connected to the first wiring layer 4; a pad portion for a via 7 disposed on a surface of the elastic insulating layer 5 that is opposite side to the first wiring layer 4, and electrically connected to the via 6; and a pad portion for connecting a wiring board 8 disposed on a surface of the elastic insulating layer 5 that is opposite side to the first wiring layer 4, and to be electrically connected to a wiring board. The elastic insulating layer 5 has a convexoconcave shape 9, including a plurality of convex portions 9a and a plurality of concave portions 9b, on the surface that is on the side of the pad portion for a via 7 and the pad portion for connecting a wiring board 8.

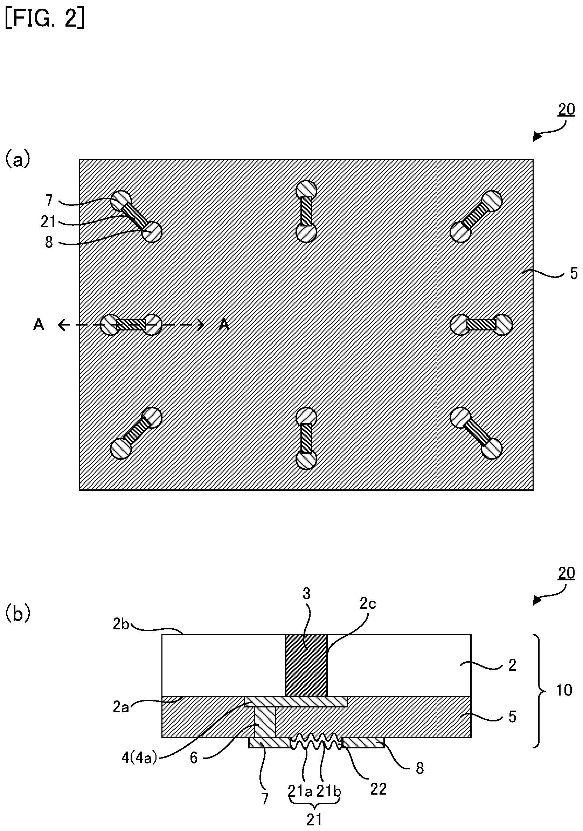

FIG. 2(a) and FIG. 2(b) are a schematic plan view and a cross-sectional view showing an example of a through electrode substrate including a through electrode substrate intermediate in the present embodiment, and FIG. 2(b) is an A-A line cross-sectional view of FIG. 2(a). FIG. 2(a) and FIG. 2(b) are examples of a through electrode substrate including the through electrode substrate intermediate shown in FIG. 1(a) and FIG. 1(b). As shown in FIG. 2(a) and FIG. 2(b), the through electrode substrate 20 includes the through electrode substrate intermediate 1; and a bellows wiring layer 22 disposed on the elastic insulating layer 5 side surface of the through electrode substrate intermediate 1, including a bellows-shaped portion 21 including a plurality of mountain portions 21a and a plurality of valley portions 21b, and electrically connecting the pad portion for a via 7 and the pad portion for connecting a wiring board 8.

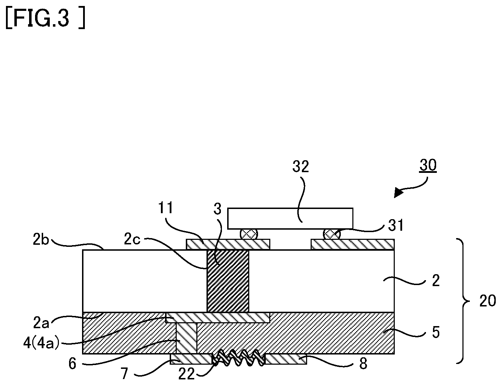

FIG. 3 is a schematic cross-sectional view illustrating an example of a through electrode substrate provided with an element including the through electrode substrate intermediate in the present embodiment. FIG. 3 is an example of a through electrode substrate provided with an element including the through electrode substrate intermediate shown in FIG. 1(a) and FIG. 1(b). As shown in FIG. 3, the through electrode substrate provided with an element 30 includes the through electrode substrate 20; the first joining portion 31 electrically connected to the pad portion for connecting an element 11 of the through electrode substrate 20; and an element 32 electrically connected to the first joining portion 31.

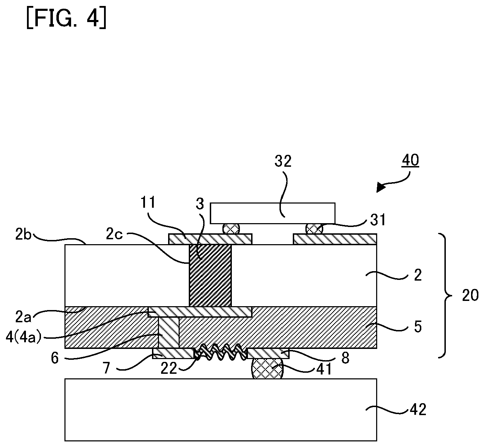

FIG. 4 is a schematic cross-sectional view illustrating an example of a semiconductor device including a through electrode substrate intermediate in the present embodiment. FIG. 4 is an example of a semiconductor device including the through electrode substrate intermediate shown in FIG. 1(a) and FIG. 1(b). As shown in FIG. 4, the semiconductor device 40 includes the through electrode substrate 20; the first joining portion 31 electrically connected to the pad portion for connecting an element 11 of the through electrode substrate 20; an element 32 electrically connected to the first joining portion 31; a second joining portion 41 electrically connected to the pad portion for connecting a wiring board 8 of the through electrode substrate 20; and a wiring board 42 electrically connected to the second joining portion 41.

For example, when the first joining portion is a solder joining portion, and when the through electrode substrate and the element are joined via the solder joining portion in the reflow process of the semiconductor device production process, the through electrode substrate and the element expand due to heat and then contract due to cooling. In this case, when the difference in thermal expansion coefficients between the through electrode substrate and the element is large, stress will be generated in the first joining portion and the pad portion for connecting an element, likely to cause cracks and disconnections. Furthermore, for example, when semiconductor devices are used in a high-temperature environment, if there is a large difference in the thermal expansion coefficient between the through electrode substrate and the element, stress will be generated in the first joining portion and the pad portion for connecting an element, likely to cause cracks and disconnections.

In contrast to this, in the present embodiment, the through electrode substrate includes a glass substrate, and the through electrode substrate is used as a so-called glass interposer. Therefore, the difference in thermal expansion coefficients between the glass substrate and the semiconductor material can be reduced, and stress generation in the first joining portion and the pad portion for connecting an element can be suppressed. Therefore, cracking and disconnection at the first joining portion and the pad portion for connecting an element can be suppressed.

Also, for example, when the second joining portion is a solder joining portion, and when the through electrode substrate and the wiring board are joined via the solder joining portion in the reflow process of the semiconductor device production process, the through electrode substrate and the wiring board expand due to heat and then contract due to cooling. In this case, if there is a large difference in the thermal expansion coefficient between the through electrode substrate and the wiring board, disconnections are likely to occur between the through electrode substrate and wiring board. Furthermore, for example, when semiconductor devices are used in a high-temperature environment, if there is a large difference in the thermal expansion coefficient between the through electrode substrate and the wiring board, stress will be generated in the second joining portion and the pad portion for connecting a wiring board, likely to cause cracks and disconnections.

In contrast to this, in the present embodiment, when the elastic insulating layer has elasticity as well as convexoconcave shape on the surface that is on the side of the pad portion for a via and the pad portion for connecting a wiring board, the surface of the elastic insulating layer that is on a side of the pad portion for a via and the pad portion for connecting a wiring board has stretchability. Also, as the surface of the elastic insulating layer that is on the side of the pad portion for a via and the pad portion for connecting a wiring board stretches, the via is deformed diagonally. Thereby, the stress due to the difference in thermal expansion coefficients between the through electrode substrate and the wiring board can be relieved by the surface of the elastic insulating layer, that is on the side of the pad portion for a via and the pad portion for connecting a wiring board, being stretched and the via being deformed diagonally. Therefore, cracking and disconnection at the second joining portion and the pad portion for connecting a wiring board can be suppressed.

Further, in the present embodiment, since the elastic insulating layer includes the convexoconcave shape on its surface, the bellows wiring layer disposed on the surface of the elastic insulating layer follows the convexoconcave shape of the elastic insulating layer so as to have a bellows-shaped portion. Also, the bellows wiring layer has stretchability due to including the bellows-shaped portion. The expansion and contraction of the bellows wiring layer further relieves the stress due to the difference in thermal expansion coefficients between the through electrode substrate and the wiring board. Therefore, cracking and disconnection at the second joining portion and the pad portion for connecting a wiring board can be effectively suppressed.

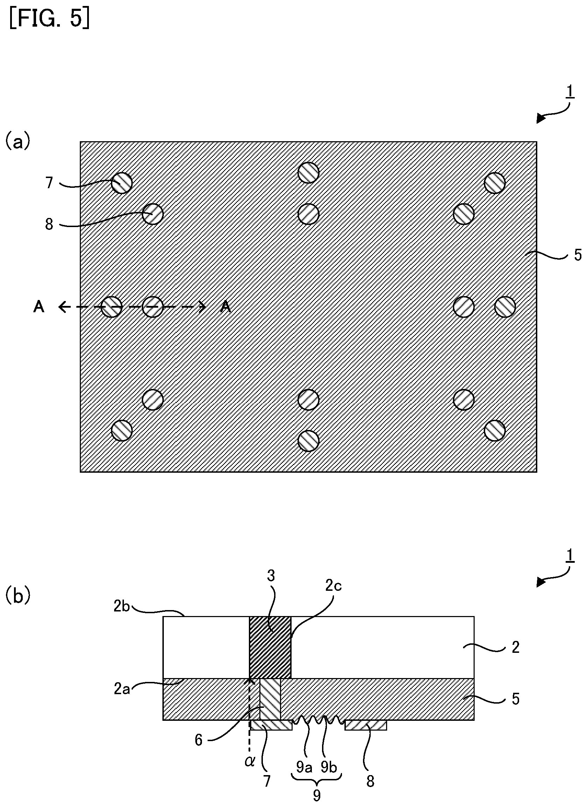

FIG. 5(a) and FIG. 5(b) are a schematic plan view and a cross-sectional view showing another example of a through electrode substrate intermediate in the present embodiment, and FIG. 5(b) is an A-A line cross-sectional view of FIG. 5(a). As shown in FIG. 5(a) and FIG. 5(b), the through electrode substrate intermediate 1 comprises a glass substrate 2 including a first surface 2a and a second surface 2b facing the first surface 2a, and including a through hole 2c; a through electrode 3 disposed in the through hole 2c of the glass substrate 2; an elastic insulating layer 5 disposed on a first surface 2a side of the glass substrate 2; a via 6 passing through the elastic insulating layer 5, and electrically connected to the through electrode 3; a pad portion for a via 7 disposed on a surface of the elastic insulating layer 5 that is opposite side to the glass substrate 2, and electrically connected to the via 6; and a pad portion for connecting a wiring board 8 disposed on a surface of the elastic insulating layer 5 that is opposite side to the glass substrate 2, and to be electrically connected to a wiring board. The elastic insulating layer 5 has a convexoconcave shape 9, including a plurality of convex portions 9a and a plurality of concave portions 9b, on the surface that is on the side of the pad portion for a via 7 and the pad portion for connecting a wiring board 8. Also, the plan-view size of the via 6 on the glass substrate 2 side surface in the elastic insulating layer 5 is smaller than the plan-view size of the through electrode 3 on the first surface 2a side surface of the glass substrate 2, and the elastic insulating layer 5 is disposed so as to cover the boundary α between the through electrode 3 and the glass substrate 2. The through electrode substrate intermediate 1 shown in FIG. 5(a) and FIG. 5(b) differs from the through electrode substrate intermediate 1 shown in FIG. 1(a) and FIG. 1(b) in that it is disposed on the first surface 2a side of the glass substrate 2, electrically connected to the through electrode 3 and the pad portion for a via 7, and does not include the first wiring layer 4 including the conductive layer 4a.

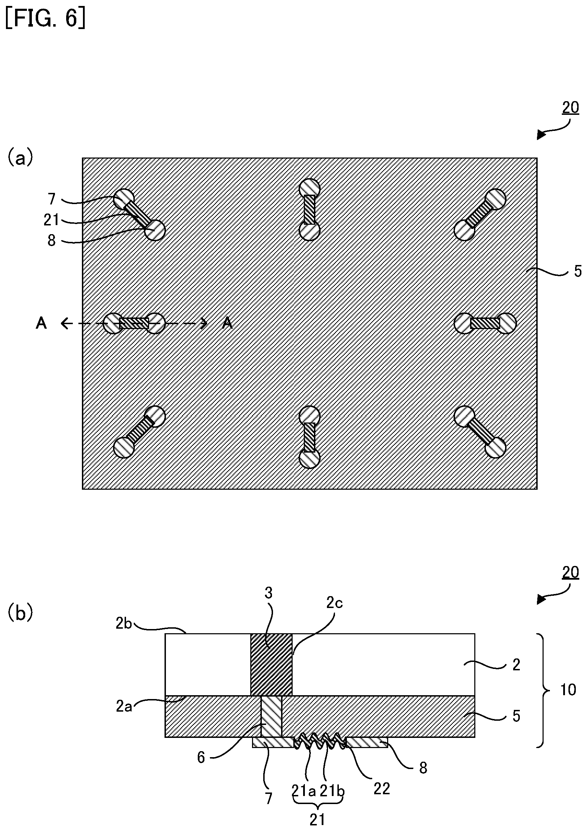

FIG. 6(a) and FIG. 6(b) are a schematic plan view and a cross-sectional view showing another example of a through electrode substrate including a through electrode substrate intermediate in the present embodiment, and FIG. 6(b) is an A-A line cross-sectional view of FIG. 6(a). FIG. 6(a) and FIG. 6(b) are examples of a through electrode substrate including the through electrode substrate intermediate shown in FIG. 5(a) and FIG. 5(b). FIG. 6(a) and FIG. 6(b) are similar to the examples shown in FIG. 2(a) and FIG. 2(b) except for the through electrode substrate intermediate.

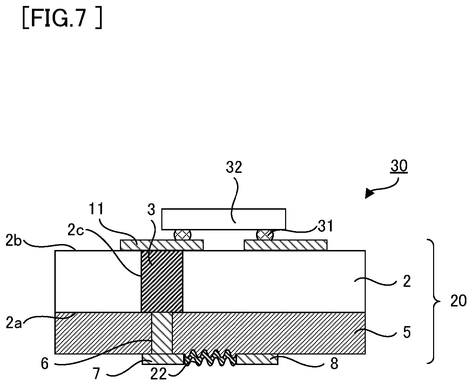

FIG. 7 is a schematic cross-sectional view illustrating another example of a through electrode substrate provided with an element including the through electrode substrate intermediate in the present embodiment. FIG. 7 is an example of a through electrode substrate provided with an element including the through electrode substrate intermediate shown in FIG. 5(a) and FIG. 5(b). FIG. 7 is similar to the example shown in FIG. 3 except for the through electrode substrate intermediate.

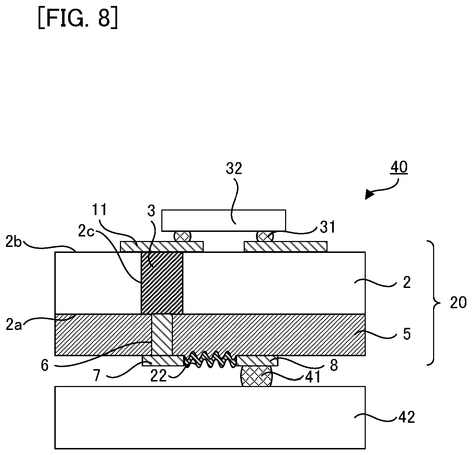

FIG. 8 is a schematic cross-sectional view illustrating another example of a semiconductor device including a through electrode substrate intermediate in the present embodiment. FIG. 8 is an example of a semiconductor device including the through electrode substrate intermediate shown in FIG. 5(a) and FIG. 5(b). FIG. 8 is similar to the example shown in FIG. 4 except for the through electrode substrate intermediate.

In the present embodiment, the effects similar to that of the through electrode substrate intermediate shown in FIG. 1(a) and FIG. 1(b) can also be obtained in the through electrode substrate intermediate shown in FIG. 5(a) and FIG. 5(b).

Therefore, in the present embodiment, the connection trustability can be improved.

Each constitution of the through electrode substrate intermediate in the present embodiment is hereinafter described.

### 1. Elastic insulating layer

The elastic insulating layer in the present embodiment is disposed on a first surface side of the glass substrate, and has a convexoconcave shape, including a plurality of convex portions and a plurality of concave portions, on the surface that is on the side of the pad portion for a via and the pad portion for connecting a wiring board.

### (1) Convexoconcave shape

The elastic insulating layer has a convexoconcave shape, including a plurality of convex portions and a plurality of concave portions, on the surface that is on the side of the pad portion for a via and the pad portion for connecting a wiring board.

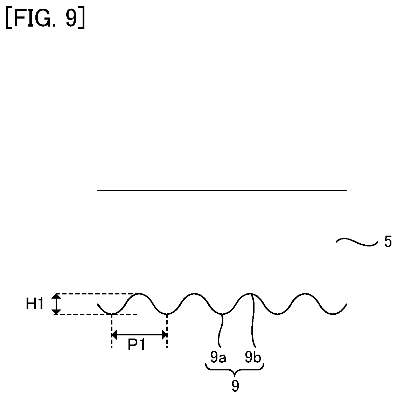

In the convexoconcave shape, the height difference between the adjacent convex portion and concave portion is preferably less than the thickness of the elastic insulating layer, in the semiconductor device including the through electrode substrate intermediate in the present embodiment. The height difference is, for example, 50 µm or less, may be 15 µm or less, and may be 10 µm or less. When the height difference is too large, the bellows wiring layer disposed on the surface of the elastic insulating layer, that is on a side of the pad portion for a via and the pad portion for connecting a wiring board, may come into contact with the wiring board. Meanwhile, the height difference is, for example, 1 µm or more, may be 3 µm or more, and may be 5 µm or more. When the height difference is too small, the stretchability of the surface of the elastic insulating layer, that is on a side of the pad portion for a via and the pad portion for connecting a wiring board, may be decreased. Specifically, the height difference is 1 µm or more and 50 µm or less, may be 3 µm or more and 15 µm or less, and may be 5 µm or more and 10 µm or less. As shown in FIG. 9 for example, the height difference between the adjacent convex portion and concave portion is indicated with a reference sign H1, and is a distance between the adjacent convex portion and concave portion in the normal line direction to the first surface of the glass substrate.

The height difference between the adjacent convex portion and concave portion is measured based on a cross-sectional image of the through electrode substrate intermediate taken with a scanning electron microscope (SEM). The height difference between the adjacent convex portion and concave portion is the arithmetic average value of the height difference at arbitrary 10 locations.

In the convexoconcave shape, the distance between the adjacent convex portions is, for example, 2 µm or more, may be 5 µm or more, and may be 6 µm or more. Meanwhile, the distance between the adjacent convex portions is, for example, 20 µm or less, may be 10 µm or less, and may be 9 µm or less. Among the above range, the distance is preferably large. When the distance is large, the stress amplitude in the bellows wiring layer disposed on the surface of the elastic insulating layer, that is on a side of the pad portion for a via and the pad portion for connecting a wiring board, can be reduced. Therefore, when the bellows wiring layer is subjected to repeated thermal stress, disconnection is suppressed and connection reliability can be improved. Specifically, the distance is 2 µm or more and 20 µm or less, may be 5 µm or more and 10 µm or less, and may be 6 µm or more and 9 µm or less. As shown in FIG. 9 for example, the distance between the adjacent convex portions is indicated with a reference sign P1.

The distance between the adjacent convex portions is measured based on a cross-sectional image of the through electrode substrate intermediate taken with a scanning electron microscope (SEM). The distance between the adjacent convex portions is the arithmetic average value of the distance at arbitrary 10 locations.

In the convexoconcave shape, the convex portions and concave portions may be arranged regularly, and may be arranged at random.

In the cross-sectional shape of the convex portion, the top portion of the convex portion preferably has a roundness, and examples of the cross-sectional shape of the convex portion may include a semi-circular shape and a semi-ellipse shape. Also, in the cross-sectional shape of the concave portion, the bottom portion of the concave portion preferably has a roundness, and examples of the cross-sectional shape of the concave portion may include a semi-circular shape and a semi-ellipse shape. With such a shape, a disconnection in the bellows wiring layer disposed on the surface of the elastic insulating layer, that is on the side of the pad portion for a via and the pad portion for connecting a wiring board, can be suppressed.

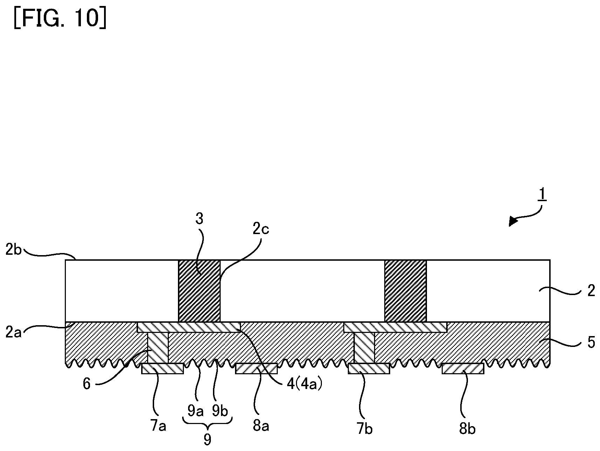

In the surface of the elastic insulating layer, that is on the side of the pad portion for a via and the pad portion for connecting a wiring board, the convexoconcave shape has only to be disposed at least in the region where the bellows wiring layer is disposed. For example, on the surface of the elastic insulating layer, that is on the side of the pad portion for a via and the pad portion for connecting a wiring board, the convexoconcave shape may be disposed on the entire surface, and the convexoconcave shape may be partially disposed. For example, in FIG. 1(b), the convexoconcave shape 9 is disposed in the region where the bellows wiring layer is disposed. In FIG. 10 for example, the convexoconcave shape 9 is disposed on not only the region where the bellows wiring layer is disposed, but also the region between the pad portion for connecting a wiring board 8 corresponding to the pad portion for a via 7 electrically connected to one of the adjacent through electrodes 3 and the pad portion for a via 7b electrically connected to the other through electrode 3. Also, in FIG. 10, the convexoconcave shape 9 is disposed in the region other than the pad portion for a via 7 and pad portion for connecting a wiring board 8. Also, although not shown in the figures, when the convexoconcave shape is disposed on the entire surface of the elastic insulating layer, that is on the side of the pad portion for a via and the pad portion for connecting a wiring board, the bellows wiring layer may also serve as the pad portion for a via and pad portion for connecting a wiring board, as described later. In this case, on the surface of the elastic insulating layer, that is on the side of the pad portion for a via and the pad portion for connecting a wiring board, the convexoconcave shape is also disposed in the region of the pad portion for a via and the pad portion for connecting a wiring board.

### (2) Properties of elastic insulating layer

In the elastic insulating layer, the elastic modulus measured by the nanoindentation method is preferably, for example, 5 GPa or less, and more preferably 1 GPa or less. When the elastic modulus is in the above range, the stress, due to the difference in thermal expansion coefficients between the through electrode substrate and the wiring board, can be relieved. Meanwhile, the elastic modulus is, for example, 0.01 GPa or more, and may be 0.05 GPa or more. Specifically, the elastic modulus is preferably 0.01 GPa or more and 5 GPa or less, and more preferably 0.05 GPa or more and 1 GPa or less.

The elastic modulus is measured by the nanoindentation method at a temperature of 25°C according to ISO 14577. As for the device, for example, "TI950 TriboIndenter" from Hysitron Inc. is used. As for the indenter, a Berkovich indenter is used. In the elastic insulating layer, the surface on which the Berkovich indenter is pressed is the surface of the elastic insulating layer that is on the side of the pad portion for a via and the pad portion for connecting a wiring board. The measurement conditions are the maximum compression depth of 100 nm, load time of 5 seconds, retention time of 5 seconds, and unloading time of 5 seconds. The measurements are carried out at arbitrary 5 locations and the arithmetic average value is regarded as the elastic modulus.

Also, in the elastic insulating layer, the thermal weight variation when heated for 1 hour at 260°C is preferably, for example, 3% or less. When the thermal weight variation is in the above range, sufficient heat resistance can be obtained.

The thermal weight variation is measured by thermogravimetric analysis (TGA). The measurement conditions are shown below. The thermogravimetric analyzer "TGA550" from TA Instruments is used.

### <Measurement conditions>

- Atmosphere: Nitrogen atmosphere
- Temperature rising rate: 10°C/min
- Retention time: 1 hour

### (3) Material of elastic insulating layer

Examples of the material of the elastic insulating layer may include elastomers. Examples of elastomer may include styrene based elastomers, olefin based elastomers, urethane based elastomers, amide based elastomers, nitrile based elastomers, vinyl chloride based elastomers, ester based elastomers, 1,2-polybutadiene based elastomers, fluorine based elastomers, silicone rubber, urethane rubber, fluorine rubber, polybutadiene, polyisobutylene, polystyrene butadiene, and polychloroprene. Also, the material of the elastic insulating layer may be photosensitive.

### (4) Structure of elastic insulating layer

In the present embodiment, as shown in FIG. 5(b) for example, the elastic insulating layer 5 is disposed so as to cover at least the boundary α between the through electrode 3 and the glass substrate 2, and may also serve as the covered insulating layer described later. The covered insulating layer is described later.

The thickness of the elastic insulating layer is, for example, 5 µm or more, may be 15 µm or more, and may be 50 µm or more. When the thickness of the elastic insulating layer is in the above range, the stretchability of the surface of the elastic insulating layer, that is on the side of the pad portion for a via and the pad portion for connecting a wiring board, is improved. Meanwhile, the thickness of the elastic insulating layer is, for example, 200 µm or less, may be 100 µm or less, and may be 60 µm or less. When the thickness of the elastic insulating layer is too thick, the thickness of the through electrode substrate intermediate as a whole may become thick. Specifically, the thickness of the elastic insulating layer is 5 µm or more and 200 µm or less, may be 15 µm or more and 100 µm or less, and may be 50 µm or more and 60 µm or less.

In the present descriptions, the thickness of each layer is measured based on a cross-sectional image of the through electrode substrate intermediate taken with a scanning electron microscope (SEM). The thickness is the arithmetic average value of the thickness at arbitrary 5 locations.

### (5) Method for forming elastic insulating layer

The elastic insulating layer can be formed by applying the material described above. Also, examples of the method for forming a convexoconcave shape may include a shaping using a mold.

### 2. Via

The via in the present embodiment passes through the elastic insulating layer, and is electrically connected to the through electrode.

The material for the via is not particularly limited as long as it is a material having conductivity, and conductive material used for a general via can be used, and is appropriately selected according to the aspect or forming method of the via.

Methods for forming a general via can be used for the method for forming a via, and it is appropriately selected according to the aspect of the via. In the method for forming a via, a through hole is firstly formed in the elastic insulating layer, and then a via is formed in the through hole of the elastic insulating layer. Examples of the method for forming a through hole in an elastic insulating layer may include laser processing, photolithography method, and shaping using a mold. In the case of shaping using a mold, a mold may be used to form a convexoconcave shape on the surface of the elastic insulating layer by shaping, and at the same time, a through hole may be formed in the elastic insulating layer by shaping using this mold. Also, examples of the method for forming a via in the through hole of the elastic insulating layer may include PVD method such as vacuum deposition and sputtering; CVD method; and plating method. A conductive material may be filled into the through hole of the elastic insulating layer to form a via, and at the same time, the pad portion for a via may be formed with this conductive material. In the case of the plating method, first, a through hole is formed in the elastic insulating layer, then a seed layer is formed on the entire surface of the elastic insulating layer by, for example, sputtering, then a photoresist layer is formed on the seed layer, then the photoresist layer is patterned to have opening portion for the pad portion for a via, and then electroplating is applied to the opening portion in the photoresist layer to form a plating layer, thereby simultaneously forming the via and the pad portion for a via. In this case, the via and the pad portion for a via include a seed layer and a plating layer.

### 3. Pad portion for via

The pad portion for a via in the present embodiment is disposed on the surface of the elastic insulating layer, that is opposite side to the glass substrate, and is electrically connected to the via.

The material of the pad portion for a via is not particularly limited as long as it is a material having conductivity, and conductive material used for general wires can be used. As the conductive material, for example, metals such as copper, molybdenum, titanium, tungsten, tantalum, aluminum, gold, silver, nickel and palladium; alloys including at least one selected from these metals; or metal oxides such as indium tin oxide (ITO) and indium zinc oxide (IZO) can be used. Among them, copper is preferably used.

Examples of the plan-view shape of the pad portion for a via is not particularly limited, and may include a circular shape, an oval shape, a square shape, and a rectangular shape.

The thickness of the pad portion for a via is similar to the thickness of a typical wire. The thickness of the pad portion for a via is, for example, 0.05 µm or more and 100 µm or less, may be 0.1 µm or more and 50 µm or less, and may be 0.2 µm or more and 10 µm or less. Thereby, sufficient conductivity can be obtained.

General method for forming wiring can be used as the method for forming a pad portion for a via, and examples thereof may include methods wherein a conductive film is formed by, for example, a dry film deposition method such as CVD method or PVD method such as sputtering method, or by a plating method, and then, the conductive film is patterned by photolithography method. Also, as described above, the via and the pad portion for a via may be formed at a same time.

### 4. Pad portion for connecting wiring board

The pad portion for connecting a wiring board in the present embodiment is disposed on the surface of the elastic insulating layer that is opposite side to the glass substrate, and to be electrically connected to the wiring board.

The material, plan-view shape, thickness, forming method of the pad portion for connecting a wiring board are similar to the material, plan-view shape, thickness, forming method of the pad portion for a via described above.

The pad portion for a via and pad portion for connecting a wiring board are electrically connected by a bellows wiring layer. Therefore, the pad portion for a via and pad portion for connecting a wiring board are disposed in close proximity.

In this case, the distance from the pad portion for a via to the pad portion for connecting a wiring board is set appropriately according to the size of the through electrode substrate intermediate, and for example, it may be 50 µm or more, and may be 200 µm or more. When the distance is too short, the length of the bellows wiring layer tends to be shortened, making it difficult for the bellows wiring layer to expand or contract so that it may be easily disconnected. When the distance is in the above range, the length of the bellows wiring layer can be secured and the stress amplitude can be reduced. Therefore, when the bellows wiring layer is subjected to repeated thermal stress, disconnection is suppressed and connection reliability can be maintained. Meanwhile, the distance is, for example, 1000 µm or less, may be 500 µm or less, and may be 300 µm or less. When the distance is too long, the length of the bellows wiring layer tends to be long, the electric properties may be deteriorated. Specifically, the distance is 50 µm or more and 1000 µm or less, may be 100 µm or more and 500 µm or less, and may be 200 µm or more and 300 µm or less. The distance from the pad portion for a via to the pad portion for connecting a wiring board refers to the distance from the center of the pad portion for a via to the center of the pad portion for connecting a wiring board.

Incidentally, when the convexoconcave shape is disposed on the entire surface of the elastic insulating layer, that is on the side of the pad portion for a via and the pad portion for connecting a wiring board as described above, it is difficult to demarcate the pad portion for a via and the pad portion for connecting a wiring board, in a case where the bellows wiring layer also serves as the pad portion for a via and the pad portion for connecting a wiring board as described later. In such a case, the distance from the via passing through the elastic insulating layer of the through electrode substrate intermediate to the first joining portion, in the semiconductor device including the through electrode substrate intermediate, may be in the above range. The distance from the via to the first joining portion refers to the distance from the center of the via to the center of the first joining portion.

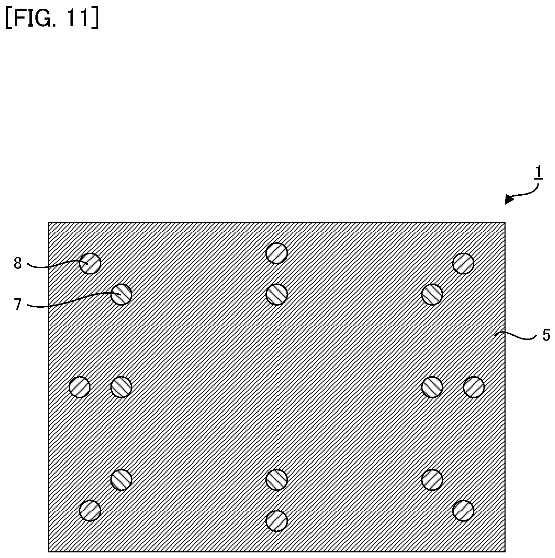

As shown in FIG. 1(a) and FIG. 11 for example, the pad portion for a via 7 and the pad portion for connecting a wiring board 8 are preferably disposed radially in a plan view. This makes it easier to relieve stress due to the difference in thermal expansion coefficients between the through electrode substrate and the wiring board. In this case, as shown in FIG. 1(a), the pad portion for a via 7 and the pad portion for connecting a wiring board 8 may be disposed radially so that the pad portion for a via 7 is disposed on the outside and the pad portion for connecting a wiring board 8 is disposed on the inside. Also, as shown in FIG. 11, the pad portion for a via 7 and the pad portion for connecting a wiring board 8 may be disposed radially so that the pad portion for a via 7 is disposed on the inside and the pad portion for connecting a wiring board 8 is disposed on the outside.

Among them, the pad portion for a via 7 and the pad portion for connecting a wiring board 8 are preferably disposed radially so that the pad portion for a via 7 is disposed on the inside and the pad portion for connecting a wiring board 8 is disposed on the outside, as shown in FIG. 11. When the pad portion for connecting a wiring board is disposed on the outer side than the pad portion for a via in the semiconductor device including the through electrode substrate intermediate, the through electrode substrate and the wiring board are electrically connected, and the second joining portion supporting the through electrode substrate is disposed on the outside. Therefore, the through electrode substrate and the wiring board are stabilized horizontally. This allows the soldering process to be carried out stably. Also, when the pad portion for connecting a wiring board is disposed on the outer side than the pad portion for a via, compressive stress is applied to the bellows wiring layer, in relation to the stress due to the difference in the thermal expansion coefficient between the through electrode substrate and the wiring board. Meanwhile, when the pad portion for connecting a wiring board is disposed on the inner side than the pad portion for a via, tensile stress is applied to the bellows wiring layer, in relation to the stress due to the difference in the thermal expansion coefficient between the through electrode substrate and the wiring board. In the case of compressive stress, the bellows wiring layer is less likely to be disconnected, compared to tensile stress. Therefore, it is preferable that the pad portion for connecting a wiring board is disposed on the outer side than the pad portion for a via.

Also, the pad portion for connecting a wiring board is preferably disposed regularly in a plan view. As a result, in the production process of a semiconductor device using the through electrode substrate intermediate, the heat history applied to the second joining portion, that electrically connects the through electrode substrate and wiring board, will be uniform. As a result, the yield is improved.

### 5. Glass substrate

The glass substrate in the present embodiment includes a first surface and a second surface facing the first surface, and includes a through hole passing through in the thickness direction.

Since the glass substrate has good flatness, fine wiring can be formed with a narrow pitch. Also, since the thermal expansion coefficient of the glass substrate can be adjusted according to the composition thereof, a glass substrate with preferable thermal expansion coefficient can be selected.

Examples of the glass used for the glass substrate may include alkaline-free glass, and quartz.

The thermal expansion coefficient of the glass substrate is preferably, for example, 2 ppm/°C or more and 9 ppm/°C or less. When the thermal expansion coefficient of the glass substrate is in the above range, the difference between the thermal expansion coefficient of the glass substrate and the thermal expansion coefficient of the element can be sufficiently small.

In the present descriptions, the thermal expansion coefficient is the linear expansion coefficient. The thermal expansion coefficient is measured by a thermomechanical analysis (TMA) according to JIS R3102:1995.

The plan-view shape of the glass substrate is not particularly limited, and examples may include rectangular shapes such as oblong figure and square shape.

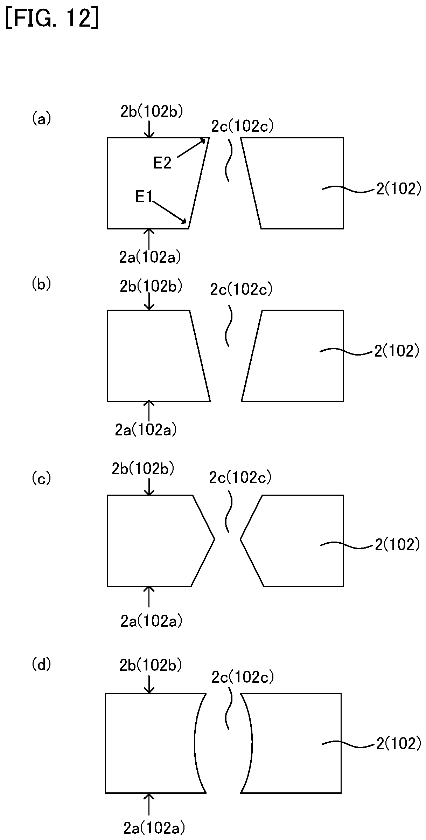

The plan-view shape of the through hole of the glass substrate is, for example, approximate circular shape. Also, examples of the cross-sectional shape of the through hole 2c of glass substrate 2 may include a straight shape as shown in FIG. 1(b); a reverse tapered shape whose aperture diameter on the first surface 2a side is larger than the aperture diameter on the second surface 2b side as shown in FIG. 12(a); a forward tapered shape whose aperture diameter on the first surface 2a side is smaller than the aperture diameter on the second surface 2b side as shown in FIG. 12(b); an hourglass shape with the smallest diameter portion at a predetermined location between the first surface 2a and the second surface 2b as shown in FIG. 12(c); and a bowing shape with the largest diameter at a predetermined location between the first surface 2a and the second surface 2b as shown in FIG. 12(d). FIG. 12(a) to FIG. 12(d) are schematic cross-sectional views illustrating an example of a cross-sectional shape of the through hole of the glass substrate. As described later, when the covered insulating layer is disposed on the first surface side of the glass substrate, the cross-sectional shape of the through hole of the glass substrate is preferably either one of the reverse tapered shape or hourglass shape. Also, in each cross-sectional shape of the through hole of the glass substrate, it is preferable that the rim portion E1 of the aperture of the through hole 2c on the first surface 2a of the glass substrate 2, the rim portion E2 of the aperture of the through hole 2c on the second surface 2b of the glass substrate 2, and the minimum portion and maximum portion of the diameter of the through hole 2c of the glass substrate 2 are curved surfaces with curvature. The disconnection in the through electrode and the via or conductive layer in contact with the through electrode can be suppressed.

The thickness of the glass substrate is, for example, 100 µm or more, may be 200 µm or more, may be 300 µm or more, and may be 400 µm or more. When the thickness of the glass substrate is in the above range, the deflection of the glass substrate can be suppressed from growing. Therefore, it is possible to suppress difficulties in handling the glass substrate during the production process, and prevent the glass substrate from warping due to internal stresses of thin films disposed on the first surface or second surface of the glass substrate. Meanwhile, the thickness of the glass substrate is, for example, 2000 µm or less, may be 1000 µm or less, and may be 800 µm or less. When the thickness of the glass substrate is in the above range, the time required for the forming process of a through hole in the glass substrate can be shortened.

### 6. Through electrode

The through electrode in the present embodiment is disposed in the through hole of the glass substrate.

The aspect of the through electrode is not particularly limited as long as the first surface and the second surface of the glass substrate can be electrically connected. The form of the through electrode may be, for example, a through electrode that fills a through hole of the glass substrate, a so-called filled via, and may be a through electrode disposed only on the side wall of the through hole of the glass substrate, a so-called conformal via. Also, when the through electrode is a conformal via, a hollow portion may be disposed in the through hole, and the through hole may be filled with a resin portion.

When the through electrode is a conformal via, and a hollow portion is disposed in the through hole, the through electrode can be formed as an integral part with the conductive layer constituting the first wiring layer, or the second wiring layer described later.

The material for the through electrode is not particularly limited as long as it is a material having conductivity, and conductive material used for general through electrode can be used, and is appropriately selected according to the aspect or forming method of the through electrode. Examples of the material of the through electrode may include metals such as copper, gold, silver, platinum, rhodium, tin, aluminum, nickel, and chromium, or alloys including these metals.

The through electrode may be a single-layer, and may be a multilayer obtained by stacking a plurality of layers. For example, the through electrode may include a seed layer disposed on the side wall of the through hole of the glass substrate, and a plating layer disposed on the surface of the seed layer that is opposite side to the side wall of the through hole. The material of the seed layer can be appropriately selected from the material used for the seed layer in the general plating method. The material of the seed layer is preferably a conductive material having close adhesiveness with respect to the glass substrate, and examples thereof may include titanium, molybdenum, tungsten, tantalum, nickel, chromium, aluminum, compounds of these, and alloys of these. When the plating layer includes copper, the material of the seed layer is preferably a material capable of suppressing copper from being diffused into the glass substrate, and examples thereof may include titanium nitride, molybdenum nitride and tantalum nitride. The material of the plating layer is preferably a conductive material having close adhesiveness with respect to the seed layer, and examples thereof may include the material of the through electrode described above.

Also, in the through electrode, a close adhesiveness layer is preferably disposed on the side wall of the through hole of the glass substrate. The close adhesiveness layer improves the close adhesiveness between the glass substrate and through electrode. The close adhesiveness layer has high close adhesiveness with respect to the glass substrate. Also, the close adhesiveness layer may also have a function of suppressing the metal element in the through electrode from being diffused into the glass substrate via the side wall of the through hole. When the through electrode includes the close adhesiveness layer, the through electrode may include a close adhesiveness layer, a seed layer, and a plating layer, in order from the side wall side of the through hole of the glass substrate.

When the conductive material constituting the through electrode is copper, examples of the material of the close adhesiveness layer may include titanium, titanium oxide, titanium nitride, molybdenum, molybdenum nitride, tantalum and tantalum nitride. Also, the close adhesiveness layer may be a single layer, and may be a multilayer. Among them, the close adhesiveness layer preferably includes titanium oxide as the main component.

Also, when the through electrode is a conformal via, and the through hole is filled with the resin portion, examples of the material of the resin portion may include epoxy resins, acrylic resins, polyimides, polyamides, and polyesters.

Methods for forming a general through electrode can be used for the method for forming the through electrode, and it is appropriately selected according to the aspect of the through electrode. Examples of the method for forming a through electrode may include PVD method such as vacuum deposition and sputtering; CVD method; and plating method.

### 7. Covered insulating layer and second via

The through electrode substrate intermediate in the present embodiment preferably includes a covered insulating layer disposed between the glass substrate and the elastic insulating layer so as to cover at least a boundary between the through electrode and the glass substrate, and including a second through hole connected to the through hole; and a second via disposed in the second through hole of the covered insulating layer, electrically connected to the through electrode, and electrically connected to the pad portion for a via.

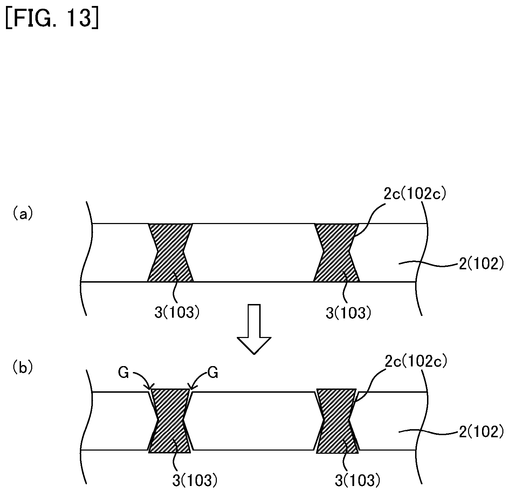

In the production of semiconductor device in which a through electrode substrate is interspersed between the element and the motherboard, heat treatment such as annealing and reflow soldering is carried out. FIG. 13(a) and FIG. 13(b) are schematic views illustrating the state of the through electrode substrate during heat treatment in the production process of a semiconductor device. In the through electrode substrate including a through electrode 3 filled in the through hole 2c as shown in FIG. 13(a), a gap G may occur between the glass substrate 2 and the through electrode 3 due to the difference in thermal expansion between the glass substrate 2 and the through electrode 3, as shown in FIG. 13(b). Also, during heat treatment, as shown in FIG. 13(b), the difference in thermal expansion between the glass substrate 2 and the through electrode 3 may cause the through electrode 3 to bulge relative to the main surface of the glass substrate 2. Furthermore, during heat treatment, residual moisture and gaseous components such as hydrogen in the material constituting the through electrode 3 may be released, causing the through electrode 3 to be pushed upward. Such gaps or bulges can cause the conductive layer or pad portion located near the boundary between the through electrode and the glass substrate to disconnect. Also, the wire connected to the pad portion may disconnect.

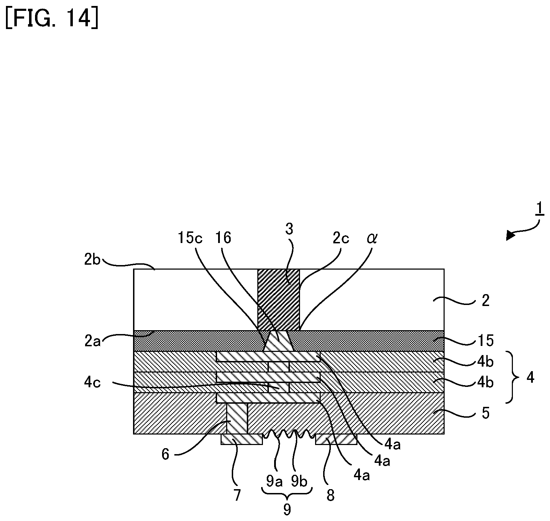

In FIG. 14, the through electrode substrate intermediate 1 includes a covered insulating layer 15 disposed between the glass substrate 2 and the elastic insulating layer 5 so as to cover at least the boundary α between the through electrode 3 and the glass substrate 2, and including a second through hole 15c connected to the through hole 3; and a second via 16 disposed in the second through hole 15c of the covered insulating layer 15, electrically connected to the through electrode 3, and electrically connected to the pad portion for a via 7. In FIG. 14, a first wiring layer 4 is disposed between the covered insulating layer 15 and elastic insulating layer 5, and the second via 16 is electrically connected to the via 6 and pad portion for a via 7 via the conductive layer 4a and fourth via 4c of the first wiring layer 4.

For the covered insulating layer 15, resin is used as described later. As shown in FIG. 14, when the covered insulating layer 15 is disposed so as to cover the boundary α between the glass substrate 2 and the through electrode 3, a part of the covered insulating layer 15 is in contact with a part of the through electrode 3. Therefore, even if gas is released from inside the through electrode 3 during heat treatment, that gas can be released to the outside through the covered insulating layer 15. Therefore, it is possible to suppress the occurrence of a bulge in the conductive layer 4a, which is located near the boundary α, of the first wiring layer 4. Furthermore, since the covered insulating layer 15 is disposed so as to cover the boundary α between the glass substrate 2 and the through electrode 3, even if a gap occurs between the through electrode 3 and the glass substrate 2 during heat treatment, the covered insulating layer 15 can cover the gap between the through electrode 3 and the glass substrate 2, thereby suppressing disconnection of the conductive layer 4a, which is located on the boundary α, of the first wiring layer 4. Furthermore, even if a step is created between the through electrode 3 and the glass substrate 2 due to the gap or bulge during heat treatment, the covered insulating layer 15 can absorb the step between the through electrode 3 and the glass substrate 2, thereby suppressing the occurrence of a sharp step in the conductive layer 4a, which is located near the boundary α, of the first wiring layer 4.

In the through electrode substrate intermediate 1 shown in FIGS. 5, the elastic insulating layer 5 also serve as the covered insulating layer, and the elastic insulating layer 5 is disposed so as to cover at least the boundary α between the through electrode 3 and the glass substrate 2. Also, the via 6 also serves as the second via.

For the elastic insulating layer, elastomer is used, as described above. As shown in FIGS. 5, when the elastic insulating layer 5, which also serves as a covered insulating layer, is disposed so as to cover the boundary α between the glass substrate 2 and the through electrode 3, a part of the elastic insulating layer 5 is in contact with a part of the through electrode 3. Therefore, even if gas is released from inside the through electrode 3 during heat treatment, that gas can be released to the outside through the elastic insulating layer 5. Therefore, it is possible to suppress the occurrence of a bulge in the pad portion for a via 7 located near the boundary α. Furthermore, since the elastic insulating layer 5 is disposed so as to cover the boundary α between the glass substrate 2 and the through electrode 3, even if a gap occurs between the through electrode 3 and the glass substrate 2 during heat treatment, the elastic insulating layer 5 can cover the gap between the through electrode 3 and the glass substrate 2, thereby suppressing disconnection of the pad portion for a via 7 located on the boundary α. Furthermore, even if a step is created between the through electrode 3 and the glass substrate 2 due to the gap or bulge during heat treatment, the elastic insulating layer 5 can absorb the step between the through electrode 3 and the glass substrate 2, thereby suppressing the occurrence of a sharp step in the pad portion for a via 7 located near the boundary α. Furthermore, it is possible to suppress disconnection of the bellows wiring layer connected to the pad portion for a via.

As described above, since the covered insulating layer is disposed so as to cover the boundary between the glass substrate and through electrode, it is possible to suppress the disconnection of the conductive layer or pad portion located near the boundary between the through electrode and the glass substrate. Therefore, the yield can be improved and reliability can be improved.

The covered insulating layer is preferably in direct contact with the glass substrate. The covered insulating layer includes a second through hole that passes through in the thickness direction and connected to the through hole of the glass substrate.

The material of the covered insulating layer is preferably insulating resin. Examples of the insulating resin may include polyimide, polyamide, polyamideimide, polyethylene terephthalate, polyethylene naphthalate, polyphenylene sulfide, polyetheretherketone, polyethersulfone, polycarbonate, polyetherimide, epoxy resin, phenolic resin, polyphenylene ether, acrylic resins, polyolefins, polycycloolefins, and liquid crystalline polymer compounds. Examples of the polyolefin may include polyethylene, and polypropylene. Examples of the polycycloolefin may include polynorbornene.

The method for forming the second through hole is appropriately selected according to the material of the covered insulating layer, and examples thereof may include photolithography method, and laser processing. In the case of photolithography method, the material of the covered insulating layer may be a photosensitive material, and the resist pattern may be formed on the covered insulating layer.

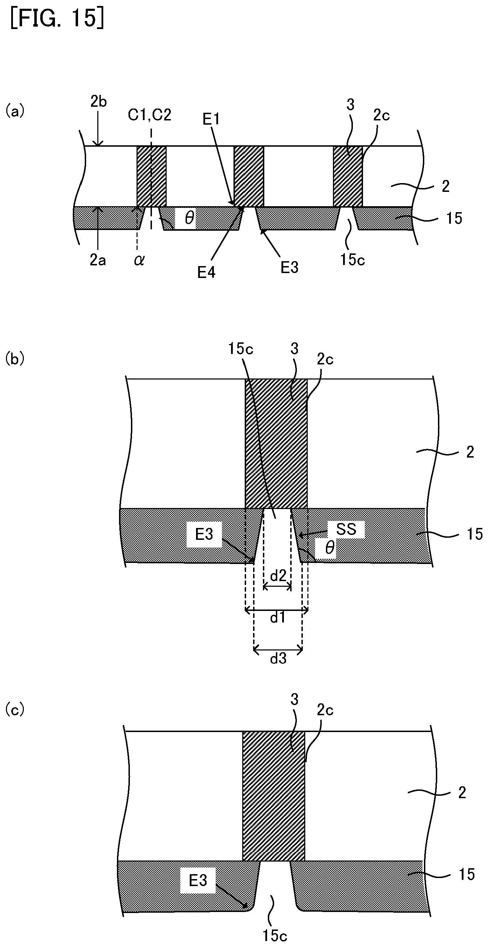

FIG. 15(a) to FIG. 15(c) are schematic cross-sectional views illustrating an example of an arrangement of a through hole of a glass substrate and a covered insulating layer of a through electrode substrate intermediate. In FIG. 15(a) to FIG. 15(c), the structures other than the glass substrate and the covered insulating layer are omitted. As shown in FIG. 15(a), the second through hole 15c of the covered insulating layer 15 is connected to the through hole 2c of the glass substrate 2. It is preferable that the central axis C1 of the through hole 2c in the glass substrate 2 approximately coincides with the central axis C2 of the second through hole 15c of the covered insulating layer 15.

Also, it is preferable that the aperture diameter d2 of the second through hole 15c of the covered insulating layer 15, on the glass substrate 2 side, is smaller than the aperture diameter d1 of the through hole 2c of the glass substrate 2, on the first surface 2a side. The ratio d2/d1 is, for example, 0.5 or more and less than 1.0, and may be 0.6 or more and 0.9 or less.

The aperture diameter d1 of the through hole 2c of the glass substrate 2, on the first surface 2a side, is, for example, 50 µm or more and 100 µm or less, and may be 60 µm or more and 90 µm or less. Meanwhile, the aperture diameter d2 of the second through hole 15c of the covered insulating layer 15, on the glass substrate 2 side, is not particularly limited, and is, for example, 40 µm or more and 85 µm or less, and may be 50 µm or more and 80 µm or less.

It is also preferable that the rim portion E4 of the aperture of the second through hole 15c, on the glass substrate 2 side surface of the covered insulating layer 2, is disposed on the inner side than the rim portion E1 of the aperture of the through hole 2c, on the first surface 2c of the glass substrate 2. Since the covered insulating layer including such the second through hole is disposed, the boundary α between the glass substrate 2 and the through electrode 3 can be covered by the covered insulating layer 15.

As shown in FIG. 15(b) for example, the cross-sectional shape of the second through hole 15c of the covered insulating layer 15 is preferably a reverse tapered shape wherein the aperture diameter d2 of the second through hole 15c, on the glass substrate 2 side, is smaller than the aperture diameter d3 on the side that is opposite to the glass substrate. When the second through hole has the reverse tapered shape, the angle θ between the side wall SS of the second through hole 15c and the surface of the covered insulating layer 2 that is opposite to the glass substrate 2 is obtuse in the cross-sectional view. Therefore, even if the through electrode 3 expands and swells, the stress can be suppressed from being concentrated near the rim portion E3 of the aperture of the second through hole 15c on the surface of the covered insulating layer 2 that is opposite side to the glass substrate 2. Therefore, disconnection of the pad portion or conductive layer, disposed on the surface of the covered insulating layer that is opposite side to the glass substrate, can be suppressed.

The angle θ is not particularly limited, and for example, it may be more than 90 degrees and 130 degrees or less, and may be 100 degrees or more and 120 degrees or less. When angle θ is in the above range, disconnection of the pad portion or conductive layer, disposed on the surface of the covered insulating layer that is opposite side to the glass substrate, can be further suppressed. Meanwhile, when the angle θ is too large, the aperture diameter d3 of the second through hole 15c, on the side that is opposite to the glass substrate 2, will be large, and it may not be suitable for high-density mounting.

As shown in FIG. 15(c), in the cross-sectional view, the rim portion E3 of the aperture of the second through hole 15c, on the surface of the covered insulating layer 15 that is opposite to the glass substrate 2, is preferably a curved surface with curvature. When the rim portion E3 is a curved surface with curvature, disconnection of the pad portion or conductive layer, disposed on the surface of the covered insulating layer that is opposite side to the glass substrate, can be further suppressed.

The second via is disposed in the second through hole of the covered insulating layer. The second via is electrically connected to the through electrode and pad portion for a via. The second via is preferably in direct contact with the through electrode.

The second via may be a via that fills the second through hole of the covered insulating layer, a so-called filled via, and may be a via disposed only on the side wall of the second through hole of the covered insulating layer, a so-called conformal via.

The material of the second via is similar to the material of the through electrode described above. The material of the through electrode and the material of the second via are preferably the same.

The second via can be formed, for example, by electrolytic plating. When the conductive layer of the first wiring layer described later is disposed on the surface of the covered insulating layer that is opposite side to the glass substrate, the second via is preferably formed at the same time as the conductive layer of the first wiring layer. Also, when the elastic insulating layer also serves as the covered insulating layer, the second via can be formed at the same time as the pad portion for a via.

### 8. Second covered insulating layer and third via

The through electrode substrate intermediate in the present embodiment preferably includes a second covered insulating layer disposed on the second surface side of the glass substrate so as to cover at least a boundary between the through electrode and the glass substrate, and including a third through hole connected to the through hole; and a third via disposed in the third through hole of the second covered insulating layer, and electrically connected to the through electrode.

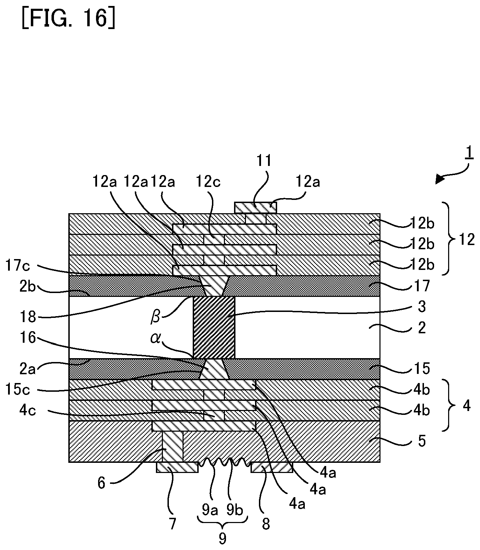

In FIG. 16, the through electrode substrate intermediate 1 includes a covered insulating layer 17 disposed on the second surface 2b side of the glass substrate 2 so as to cover at least the boundary β between the through electrode 3 and the glass substrate 2, and includes a third through hole 17c connected to the through hole 3; and a third via 18 disposed in the third through hole 17c of the second covered insulating layer 17, electrically connected to the through electrode 3, and electrically connected to the pad portion for connecting an element 11. In FIG. 16, a second wiring layer 12 is disposed on the surface of the second covered insulating layer 17 that is opposite side to the glass substrate 2, and the third via 18 is electrically connected to the pad portion for connecting an element 11 via the conductive layer 12a and fifth via 12c of the second wiring layer 12.

The second covered insulating layer exhibits an effect similar to the covered insulating layer described above. The second covered insulating layer and third via are respectively similar to the covered insulating layer and second via described above.

### 9. First wiring layer

The through electrode substrate intermediate in the present embodiment may include a first wiring layer disposed between the glass substrate and elastic insulating layer, and electrically connected to the through electrode.

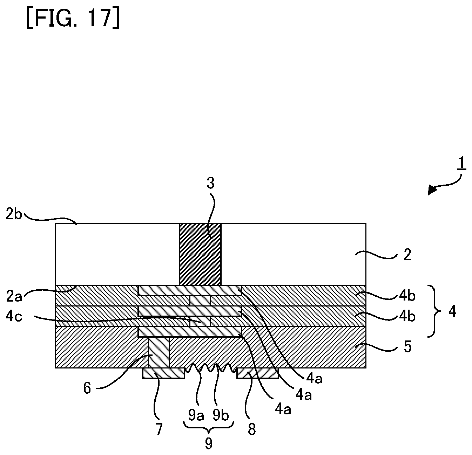

The first wiring layer includes at least a conductive layer and may further include an interlayer insulating layer. The conductive layer may be 1 layer, and may be 2 layers or more. When the first wiring layer includes 2 layers or more conductive layers, each conductive layer is stacked in the thickness direction via the interlayer insulating layer. Also, each conductive layer is electrically connected via the via. In FIG. 17 for example, the first wiring layer 4 includes, in order from the glass substrate 2 side, a conductive layer 4a, interlayer insulating layer 4b, conductive layer 4a, interlayer insulating layer 4b, and conductive layer 4a, and each conductive layer 4a is electrically connected by the fourth via 4c.

The material of the conductive layer is not particularly limited as long as it is a material having conductivity, and conductive material generally used for wires of interposers can be used. Examples of the conductive material may include metal materials such as metals and metal oxides; conductive resins including conductive fillers and resins; and conductive polymers.

The thickness of the conductive layer is, for example, 0.1 µm or more, may be 0.5 µm or more, may be 1 µm or more, may be 3 µm or more, and may be 5 µm or more. Meanwhile, the thickness of the conductive layer is, for example, 20 µm or less, and may be 15 µm or less. The thickness of the conductive layer is, for example, 0.1 µm or more and 20 µm or less, may be 0.5 µm or more and 15 µm or less, may be 1 µm or more and 15 µm or less, may be 3 µm or more and 15 µm or less, and may be 5 µm or more and 15 µm or less. For example, when the conductive layer is formed by the sputtering method, a relatively thin conductive layer can be obtained. Also, a relatively thick conductive layer can be obtained, for example, when the conductive layer is formed by plating methods.

The method for forming the conductive layer may be an additive method, and may be a subtractive method. In the additive method, for example, a patterned wiring layer is obtained by forming a resist pattern by photolithography method, and plating the portion exposed from the resist pattern. When the electrolytic plating method is used, a conductive film may be formed on the first surface of the glass substrate or on the surface of the interlayer insulating layer that is opposite to the glass substrate, prior to the formation of the resist pattern. In the subtractive method, for example, a patterned wiring layer is obtained by forming a resist pattern on a conductive film formed on the entire surface of the first surface side of the glass substrate, and etching the portion exposed from the resist pattern.

The material of the interlayer insulating layer is preferably insulating resin. Examples of the insulating resin may include polyimide, polyamide, polyamideimide, polyethylene terephthalate, polyethylene naphthalate, polyphenylene sulfide, polyetheretherketone, polyethersulfone, polycarbonate, polyetherimide, epoxy resin, phenolic resin, polyphenylene ether, acrylic resins, polyolefins, polycycloolefins, and liquid crystalline polymer compounds. Examples of the polyolefin may include polyethylene, and polypropylene. Examples of the polycycloolefin may include polynorbornene.

The thickness of the interlayer insulating layer is, for example, 1.5 µm or more, and may be 2.5 µm or more. Meanwhile, the thickness of the interlayer insulating layer is, for example, 6 µm or less. The thickness of the interlayer insulating layer is, for example, 1.5 µm or more and 6 µm or less, and may be 2.5 µm or more and 6 µm or less.

Examples of the method for forming an interlayer insulating layer may include a photolithography method and a printing method.

### 10. Second wiring layer

The through electrode substrate intermediate in the present embodiment may include a second wiring layer disposed on the second surface side of the glass substrate, and electrically connected to the through electrode.

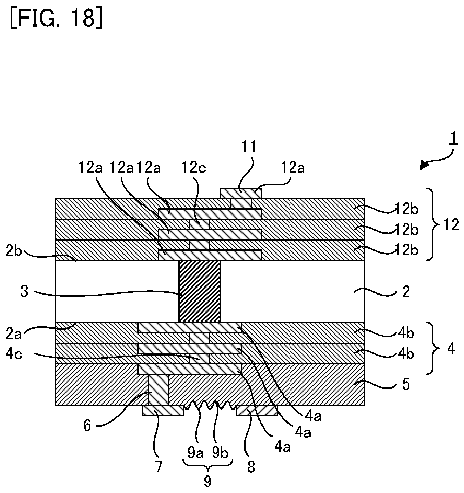

The second wiring layer includes at least a conductive layer, and may further include an interlayer insulating layer. The conductive layer may be 1 layer, and may be 2 layers or more. When the second wiring layer includes 2 layers or more conductive layers, each conductive layer is stacked in the thickness direction via the interlayer insulating layer. Also, each conductive layer is electrically connected via the via. For example, in FIG. 18, the second wiring layer 12 includes, in order from the glass substrate 2 side, the conductive layer 12a, interlayer insulating layer 12b, conductive layer 12a, interlayer insulating layer 12b, conductive layer 12a, interlayer insulating layer 12b, and conductive layer 12a, and each conductive layer 12a is electrically connected by the fifth via 12c. The conductive layer 12a, which is located on the surface of the second wiring layer 12 that is opposite side to the glass substrate 2, includes a pad portion for connecting an element 11.

The conductive layer and the interlayer insulating layer in the second wiring layer are similar to the conductive layer and the interlayer insulating layer in the first wiring layer described above.

The plan-view shape of the pad portion for connecting an element is similar to the plan-view shape of the pad portion for a via described above.

### B. Through electrode substrate

The through electrode substrate in the present embodiment includes the through electrode substrate intermediate described above; and a bellows wiring layer disposed on the elastic insulating layer side surface of the through electrode substrate intermediate, including a bellows-shaped portion including a plurality of mountain portions and a plurality of valley portions, and electrically connecting the pad portion for a via and the pad portion for connecting a wiring board.

FIG. 2(a) and FIG. 2(b) are a schematic plan view and cross-sectional view showing an example of a through electrode substrate in the present embodiment, and FIG. 2(b) is an A-A line cross-sectional view of FIG. 2(a). As shown in FIG. 2(a) and FIG. 2(b), the through electrode substrate 20 includes the through electrode substrate intermediate 1 described above; and a bellows wiring layer 22 disposed on the elastic insulating layer 5 side surface of the through electrode substrate intermediate 1, including a bellows-shaped portion 21 including a plurality of mountain portions 21a and a plurality of valley portions 21b, and electrically connecting the pad portion for a via 7 and the pad portion for connecting a wiring board 8.

FIG. 3 is a schematic cross-sectional view illustrating an example of a through electrode substrate provided with an element including a through electrode substrate in the present embodiment. As shown in FIG. 3, the through electrode substrate provided with an element 30 includes the through electrode substrate 20; the first joining portion 31 electrically connected to the pad portion for connecting an element 11 of the through electrode substrate 20; and an element 32 electrically connected to the first joining portion 31.

FIG. 4 is a schematic cross-sectional view illustrating an example of a semiconductor device including a through electrode substrate in the present embodiment. As shown in FIG. 4, the semiconductor device 40 includes the through electrode substrate 20; the first joining portion 31 electrically connected to the pad portion for connecting an element 11 of the through electrode substrate 20; an element 32 electrically connected to the first joining portion 31; a second joining portion 41 electrically connected to the pad portion for connecting a wiring board 8 of the through electrode substrate 20; and a wiring board 42 electrically connected to the second joining portion 41.

In the present embodiment, as described in the section "A. Through electrode substrate intermediate" above, the through electrode substrate includes a glass substrate, and the through electrode substrate is used as a so-called glass interposer. Therefore, the difference in thermal expansion coefficients between the glass substrate and the semiconductor material can be reduced, and stress generation in the first joining portion and the pad portion for connecting an element can be suppressed. Therefore, cracking and disconnection at the first joining portion and the pad portion for connecting an element can be suppressed.

Also, in the present embodiment, as described in the section "A. Through electrode substrate intermediate" above, when the elastic insulating layer has elasticity as well as convexoconcave shape on the surface that is on a side of the pad portion for a via and the pad portion for connecting a wiring board, the surface of the elastic insulating layer that is on the side of the pad portion for a via and the pad portion for connecting a wiring board has stretchability. Also, as the surface of the elastic insulating layer that is on the side of the pad portion for a via and the pad portion for connecting a wiring board stretches, the via is deformed diagonally. Thereby, the stress due to the difference in thermal expansion coefficients between the through electrode substrate and the wiring board can be relieved by the surface of the elastic insulating layer, that is on the side of the pad portion for a via and the pad portion for connecting a wiring board, being stretched and the via being deformed diagonally. Therefore, cracking and disconnection at the second joining portion and the pad portion for connecting an element can be suppressed.

Further, in the present embodiment, as described in the section "A. Through electrode substrate intermediate" above, since the elastic insulating layer includes the convexoconcave shape on its surface, the bellows wiring layer disposed on the surface of the elastic insulating layer follows the convexoconcave shape of the elastic insulating layer so as to have a bellows-shaped portion. Also, the bellows wiring layer has stretchability due to including the bellows-shaped portion. The expansion and contraction of the bellows wiring layer further relieves the stress due to the difference in thermal expansion coefficients between the through electrode substrate and the wiring board. Therefore, cracking and disconnection at the second joining portion and the pad portion for connecting an element can be suppressed effectively.

Therefore, in the present embodiment, the connection trustability can be improved.

Each constitution of the through electrode substrate in the present embodiment is hereinafter described.

### 1. Through electrode substrate intermediate

Since the through electrode substrate intermediate is described in the section "A. Through electrode substrate intermediate" above in detail, the description herein is omitted.

### 2. Bellows wiring layer

The bellows wiring layer in the present embodiment is disposed on the elastic insulating layer side surface of the through electrode substrate intermediate, including a bellows-shaped portion including a plurality of mountain portions and a plurality of valley portions, and electrically connecting the pad portion for a via and the pad portion for connecting a wiring board.

### (1) Bellows-shaped portion

The bellows wiring layer includes a bellows-shaped portion including a plurality of mountain portions and a plurality of valley portions.

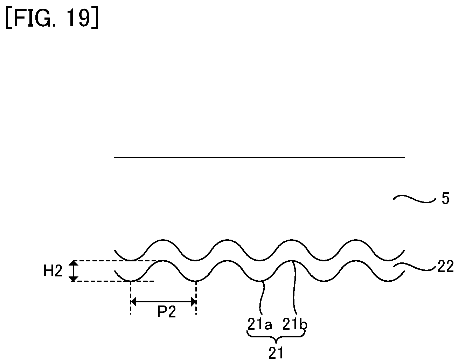

In the bellows-shaped portion, the height difference between the adjacent mountain portion and valley portion is preferably less than the thickness of the second joining portion that electrically connects the through electrode substrate and wiring board, in the semiconductor device including the through electrode substrate in the present embodiment. The height difference is, for example, 50 µm or less, may be 15 µm or less, and may be 10 µm or less. When the height difference is too large, the bellows wiring layer may become into contact with the wiring board. Meanwhile, the height difference is, for example, 1 µm or more, may be 3 µm or more, and may be 5 µm or more. When the height difference is too small, the stretchability of the bellows wiring layer may be decreased. The height difference is, for example, 1 µm or more and 50 µm or less, may be 3 µm or more and 15 µm or less, and may be 5 µm or more and 10 µm or less. As shown in FIG. 19 for example, the height difference between the adjacent mountain portion and valley portion is indicated with a reference sign H2, and is a distance between the adjacent mountain portion and valley portion in the normal line direction to the first surface of the glass substrate.

The height difference between the adjacent mountain portion and valley portion is measured based on a cross-sectional image of the through electrode substrate taken with a scanning electron microscope (SEM). The height difference between the adjacent mountain portion and valley portion is the arithmetic average value of the height difference at arbitrary 10 locations.

In the bellows-shaped portion, the distance between the adjacent mountain portions is, for example, 2 µm or more, may be 5 µm or more, and may be 6 µm or more. Meanwhile, the distance between the adjacent mountain portions is, for example, 20 µm or less, may be 10 µm or less, and may be 9 µm or less. Among the above range, the distance is preferably large. When the distance is large, the stress amplitude in the bellows wiring layer can be reduced. Therefore, when the bellows wiring layer is subjected to repeated thermal stress, disconnection is suppressed and connection reliability can be improved. Specifically, the distance is 2 µm or more and 20 µm or less, may be 5 µm or more and 10 µm or less, and may be 6 µm or more and 9 µm or less. As shown in FIG. 19 for example, the distance between the adjacent mountain portions is indicated with a reference sign P2.

The distance between the adjacent mountain portions is measured based on a cross-sectional image of the through electrode substrate taken with a scanning electron microscope (SEM). The distance between the adjacent mountain portions is the arithmetic average value of the distance at arbitrary 10 locations.

In the bellows-shaped portion, the mountain portions and valley portions may be arranged regularly, and may be arranged at random.

### (2) Structure of bellows wiring layer

The bellows wiring layer is disposed so as to electrically connect the pad portion for a via and pad portion for connecting a wiring board.

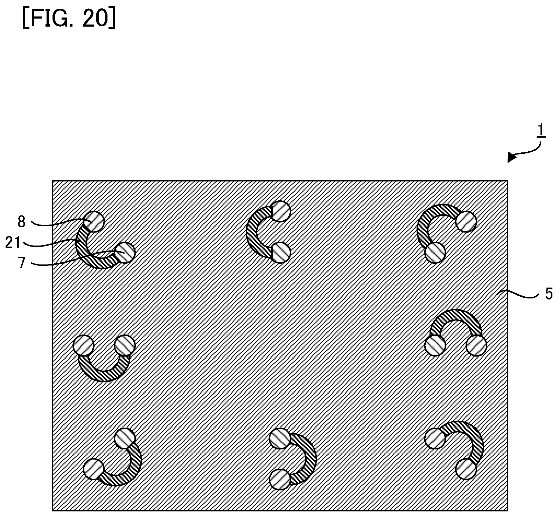

The plan-view shape of the bellows wiring layer only needs to be arranged so that the bellows wiring layer electrically connects the pad portion for a via and pad portion for connecting a wiring board, and examples thereof may include straight lines as shown in FIG. 2(a), curves as shown in FIG. 20, and although not shown in the figures, dashed lines, zigzag lines, and right-angle lines. When the plan-view shape of the bellows wiring layer is not a straight, the length of the bellows wiring layer becomes longer. Therefore, the stress amplitude can be reduced. Therefore, when the bellows wiring layer is subjected to repeated thermal stress, disconnection is suppressed and connection reliability can be improved.

The length of the bellows wiring layer is set appropriately according to the size of the through electrode substrate, and is preferably, for example, 50 µm or more, may be 100 µm or more, and may be 200 µm or more. When the length of the bellows wiring layer is too short, it may be difficult for the bellows wiring layer to expand or contract so that it may be easily disconnect. When the length of the bellows wiring layer is in the above range, the stress amplitude can be reduced.

Therefore, when the bellows wiring layer is subjected to repeated thermal stress, disconnection is suppressed and connection reliability can be maintained. Meanwhile, the length of the bellows wiring layer is, for example, 1000 µm or less, may be 500 µm or less, and may be 300 µm or less. When the length of the bellows wiring layer is too long, the electric properties may be deteriorated. Specifically, the length of the bellows wiring layer is 50 µm or more and 1000 µm or less, may be 100 µm or more and 500 µm or less, and may be 200 µm or more and 300 µm or less. The length of the bellows wiring layer refers to the length of the bellows wiring layer in a plan view.

The thickness of the bellows wiring layer is not particularly limited. For example, when the material of the bellows wiring layer does not have stretchability as described later, the thickness of the bellows wiring layer is, for example, 1 nm or more, may be 100 nm or more, and may be 1000 nm or more. Also, in this case, the thickness of the bellows wiring layer is, for example, 100 µm or less, may be 10 µm or less, and may be 3 µm or less. That is, in this case, the thickness of the bellows wiring layer is, for example, 1 nm or more and 100 µm or less, may be 100 nm or more and 10 µm or less, and may be 1000 nm or more and 3 µm or less. Meanwhile, when the material of the bellows wiring layer has stretchability as described later, the thickness of the bellows wiring layer is, for example, 5 µm or more, may be 10 µm or more, and may be 20 µm or more. Also, in this case, the thickness of the bellows wiring layer is, for example, 60 µm or less, may be 50 µm or less, and may be 40 µm or less. That is, in this case, the thickness of the bellows wiring layer is, for example, 5 µm or more and 60 µm or less, may be 10 µm or more and 50 µm or less, and may be 20 µm or more and 40 µm or less.

The width of the bellows wiring layer is, for example, 10 µm or more and 100 µm or less.

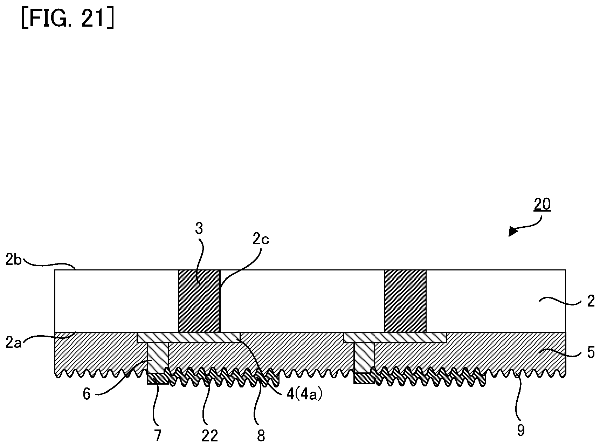

As described above, when the convexoconcave shape is disposed on the entire surface of the elastic insulating layer, that is on the side of the pad portion for a via and the pad portion for connecting a wiring board, the bellows wiring layer may also serve as the pad portion for a via and pad portion for connecting a wiring board. In FIG. 21 for example, the convexoconcave shape 9 is disposed on the entire surface of the elastic insulating layer 5, that is on the side of the pad portion for a via 7 and the pad portion for connecting a wiring board 8, the bellows wiring layer 22 also serves as the pad portion for a via 7 and pad portion for connecting a wiring board 8. In this case, on the surface of the elastic insulating layer, that is on the side of the pad portion for a via and the pad portion for connecting a wiring board, the convexoconcave shape is also disposed in the region of the pad portion for a via and the pad portion for connecting a wiring board.

### (3) Properties of bellows wiring layer

In the bellows wiring layer, the elastic modulus measured by the nanoindentation method is, for example, 100 MPa or more, and may be 200 MPa or more. Meanwhile, the elastic modulus is, for example, 3000 GPa or less, may be 200 GPa or less, and may be 100 GPa or less. That is, the elastic modulus is 100 MPa or more and 300 GPa or less, may be 100 MPa or more and 200 GPa or less, may be 200 MPa or more and 200 GPa or less, and may be 200 MPa or more and 100 GPa or less.

### (4) Material of bellows wiring layer

The material of the bellows wiring layer may or may not have a stretchability. Examples of the material not having stretchability may include metals such as gold, silver, copper, aluminum, platinum, and chromium, as well as alloys including these metals. Meanwhile, examples of the material having stretchability may include conductive compositions including conductive particles and elastomers. In this case, the bellows wiring layer includes conductive particles and elastomers. Examples of the conductive particles may include particles such as gold, silver, copper, nickel, palladium, platinum, and carbon. Examples of elastomer may include styrene based elastomers, acrylic based elastomers, olefin based elastomers, urethane based elastomers, silicone rubber, urethane rubber, fluorine rubber, nitrile rubber, polybutadiene, and polychloroprene.

### (5) Method for forming bellows wiring layer

The method for forming the bellows wiring layer is not particularly limited. For example, when the material of the bellows wiring layer does not have stretchability, examples of the method may include a method wherein a conductive film is formed by, for example, vapor deposition, sputtering, plating, transfer or pressure adhering a metal foil, and then, the conductive film is patterned by photolithography method. Meanwhile, when the material of the bellows wiring layer has stretchability, examples of the method may include a method wherein a conductive composition including conductive particles and an elastomer is printed in a pattern by a general printing method.

### 3. First polymer layer

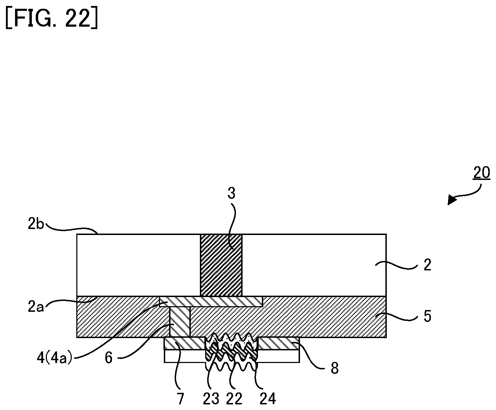

The through electrode substrate in the present embodiment preferably includes a first polymer layer between the elastic insulating layer and the bellows wiring layer. For example, in FIG. 22, a first polymer layer 23 is disposed between the elastic insulating layer 5 and the bellows wiring layer 22. The first polymer layer reduces stress and stress amplitude on the bellows wiring layer.

The elastic modulus of the first polymer layer is preferably more than the elastic modulus of the elastic insulating layer. When the elastic modulus of the first polymer layer is less than the elastic modulus of the elastic insulating layer and is too soft, the stress applied to the bellows wiring layer may be uneven. Therefore, the stress may concentrate, and the bellows wiring layer may be disconnected.

In the first polymer layer, the elastic modulus measured by the nanoindentation method is, for example, 20 GPa or less. When the elastic modulus is too high, the bellows wiring layer may be disconnected together with the rupture of the first polymer layer. Meanwhile, as described above, the elastic modulus of the first polymer layer is preferably more than the elastic modulus of the elastic insulating layer, and the lower limit of the elastic modulus of the first polymer layer is not particularly limited.

As a material for the first polymer layer, polyimide, and parylene are preferable.

In a plan view, the first polymer layer has only to be disposed in the region where the bellows wiring layer is disposed. In particular, as shown in FIG. 22, the first polymer layer 23 is preferably not disposed in the region other than the region where the bellows wiring layer 22 is disposed. The stretchability of the surface of the elastic insulating layer, that is on the side of the pad portion for a via and the pad portion for connecting a wiring board may be suppressed by the first polymer layer.

The first polymer layer is disposed, in a plan view, to have an aperture portion on the pad portion for a via and the pad portion for connecting a wiring board, so that the bellows wiring layer is electrically connected to the pad portion for a via and the pad portion for connecting a wiring board.

The first polymer layer also has a bellows-shaped portion in the region where it overlaps the bellows wiring layer in a plan view.

The thickness of the first polymer layer is, for example, 1 nm or more and 100 µm or less.

### 4. Second polymer layer

The through electrode substrate in the present embodiment preferably includes a second polymer layer on the surface of the bellows wiring layer that is opposite side to the elastic insulating layer. For example, in FIG. 22, a second polymer layer 24 is disposed on the surface of the bellows wiring layer 22 that is opposite side to the elastic insulating layer 5. The second polymer layer can reduce stress and stress amplitude applied on the bellows wiring layer.

At least one of the first polymer layer and the second polymer layer is preferably disposed, more preferably at least the first polymer layer is disposed, and further preferably both the first polymer layer and the second polymer layer are disposed. For example, in FIG. 22, both the first polymer layer 23 and second polymer layer 24 are disposed.

The elastic modulus, material and thickness of the second polymer layer are similar to the elastic modulus, material and thickness of the first polymer layer described above.

In a plan view, the second polymer layer has only to be disposed at least in the region where the bellows wiring layer is disposed. In particular, as shown in FIG. 22, the second polymer layer 24 is preferably not disposed in the region other than the region where the bellows wiring layer 22, pad portion for a via 7 and pad portion for connecting a wiring board 8 are disposed. The stretchability of the surface of the elastic insulating layer, that is on the side of the pad portion for a via and the pad portion for connecting a wiring board, may be suppressed by the second polymer layer.

Also, as shown in FIG. 22, the second polymer layer 24 is preferably disposed so as to overlap the pad portion for a via 7 and pad portion for connecting a wiring board 8 in a plan view.

The second polymer layer also has a bellows-shaped portion in the region where it overlaps the bellows wiring layer in a plan view.

### C. Through electrode substrate provided with element

The through electrode substrate provided with an element in the present embodiment includes the through electrode substrate described above, and an element mounted on the through electrode substrate.

FIG. 3 is a schematic cross-sectional view illustrating an example of a through electrode substrate provided with an element in the present embodiment. As shown in FIG. 3, the through electrode substrate provided with an element 30 includes the through electrode substrate 20 described above; the first joining portion 31 electrically connected to the pad portion for connecting an element 11 of the through electrode substrate 20; and an element 32 electrically connected to the first joining portion 31.

Since the through electrode substrate provided with an element in the present embodiment includes the through electrode substrate described above, disconnection can be suppressed and connection reliability can be improved.

Each constitution of the through electrode substrate provided with an element in the present embodiment is hereinafter described.

### 1. Through electrode substrate

Since the through electrode substrate is described in the section "B. Through electrode substrate" above in detail, the description herein is omitted.

### 2. Element

Examples of elements in the present embodiment may include active elements such as ICs, transistors, and diodes; and passive elements such as resistors, capacitors, and inductors. Examples of the element may also include IC chips, LSI chips, and MEMS chips.

An element is mounted on the pad portion for connecting an element of the through electrode substrate via the first joining portion. As the first joining portion, a joining portion commonly used for mounting elements can be used. Examples of the materials for the first joining portion may include solder, gold or gold alloy, conductive paste, anisotropic conductive paste, and anisotropic conductive film.

Alternatively, an underfill resin portion may be provided by filling the space between the through electrode substrate and the element with underfill resin. Also, by sealing the element with mold resin, a mold resin portion may be provided to cover the element.

### D. Semiconductor device

The semiconductor device in the present embodiment includes the through electrode substrate provided with an element described above; and a wiring board electrically connected to the pad portion for connecting a wiring board of the through electrode substrate.

FIG. 4 is a schematic cross-sectional view illustrating an example of a semiconductor device in the present embodiment. As shown in FIG. 4, the semiconductor device 40 includes the through electrode substrate 20; the first joining portion 31 electrically connected to the pad portion for connecting an element 11 of the through electrode substrate 20; an element 32 electrically connected to the first joining portion 31; a second joining portion 41 electrically connected to the pad portion for connecting a wiring board 8 of the through electrode substrate 20; and a wiring board 42 electrically connected to the second joining portion 41.

Since the semiconductor device in the present embodiment includes the through electrode substrate provided with an element described above, disconnection can be suppressed and connection reliability can be improved.

Each constitution of the semiconductor device in the present embodiment is hereinafter described.

### 1. Through electrode substrate provided with element

Since the through electrode substrate provided with an element is described in the section "C. Through electrode substrate provided with element" above in detail, the description herein is omitted.

### 2. Wiring board

For the wiring board in the present embodiment, general wiring boards can be used.

The wiring board is electrically connected to the pad portion for connecting a wiring board of the through electrode substrate, via the second joining portion. The material of the second joining portion is similar to the material of the first joining portion described above.

### 3. Use application

The use application of the semiconductor device in the present embodiment is not particularly limited, and examples thereof may include laptop personal computers, tablet terminals, mobile phones, smartphones, digital video cameras, digital cameras, digital clocks, and servers.

### II. Second embodiment

Next, the details of the through electrode substrate, through electrode substrate provided with an element, and semiconductor device in the second embodiment in the present disclosure are described.

### A. Through electrode substrate

The through electrode substrate in the present embodiment comprises: a glass substrate including a first surface and a second surface facing the first surface, and including a first through hole; a through electrode disposed in the first through hole of the glass substrate; a covered insulating layer disposed on a first surface side of the glass substrate so as to cover at least a boundary between the through electrode and the glass substrate, and including a second through hole connected to the first through hole; a first via disposed in the second through hole of the covered insulating layer, and electrically connected to the through electrode; an elastic insulating layer disposed on a surface of the covered insulating layer that is opposite to the glass substrate, and including a third through hole; a second via disposed in the third through hole of the elastic insulating layer, and electrically connected to the first via; and a pad portion for connecting a wiring board disposed on a surface of the elastic insulating layer that is opposite side to the covered insulating layer, electrically connected to the second via, and to be electrically connected to a wiring board.

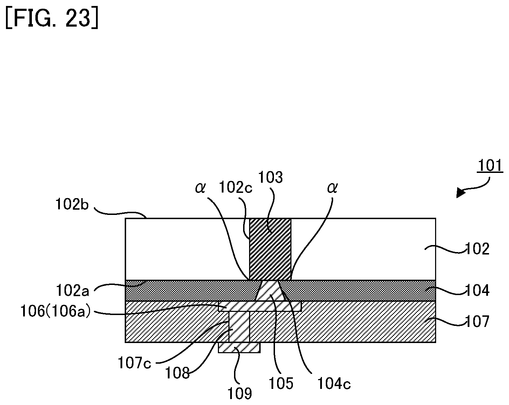

FIG. 23 is a schematic cross-sectional view illustrating an example of a through electrode substrate in the present embodiment. As shown in FIG. 23, the through electrode substrate 101 comprises: a glass substrate 102 including a first surface 102a and a second surface 102b facing the first surface 102a, and including a first through hole 102c; a through electrode 103 disposed in the first through hole 102c of the glass substrate 102; a covered insulating layer 104 disposed on a first surface 102a side of the glass substrate 102 so as to cover a boundary α between the through electrode 103 and the glass substrate 102, and including a second through hole 104c connected to the first through hole 102c; a first via 105 disposed in the second through hole 104c of the covered insulating layer 104, and electrically connected to the through electrode 103; a first wiring layer 106 disposed the surface of the covered insulating layer 104 that is opposite side to the glass substrate 102, and includes a first conductive layer 106a electrically connected to the first via 105; an elastic insulating layer 107 disposed on the surface of the covered insulating layer 104 that is opposite to the glass substrate 102, and includes a third through hole 107c; a second via 108 disposed in the third through hole 107c of the elastic insulating layer 107, and electrically connected to the first via 105 via the first conductive layer 106a of the first wiring layer 106; and a pad portion for connecting a wiring board 109 disposed on the surface of the elastic insulating layer 107 that is opposite side to the covered insulating layer 104, electrically connected to the second via 108, and to be electrically connected to a wiring board.

FIG. 23 is a schematic cross-sectional view illustrating an example of a through electrode substrate provided with an element including a through electrode substrate in the present embodiment. In FIG. 23, the through electrode substrate 101 further comprises a pad portion for connecting an element 111 disposed on a second surface 102b side of the glass substrate 102, electrically connected to the through electrode 103, and to be electrically connected to an element. As shown in FIG. 23, the through electrode substrate provided with an element 120 includes the through electrode substrate 101; the first joining portion 121 electrically connected to the pad portion for connecting an element 111 of the through electrode substrate 101; and an element 122 electrically connected to the first joining portion 121.

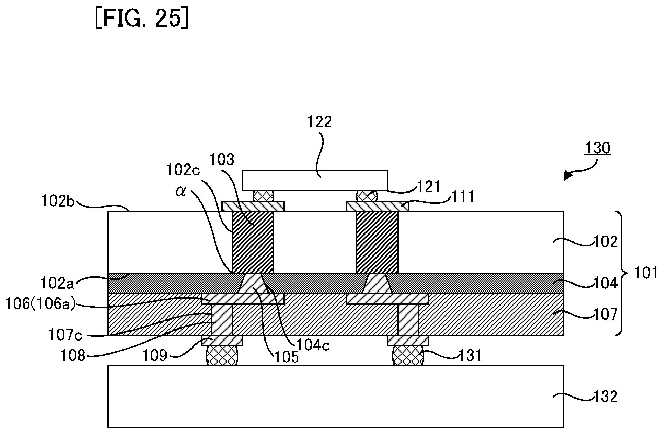

FIG. 25 is a schematic cross-sectional view illustrating an example of a semiconductor device including a through electrode substrate in the present embodiment. As shown in FIG. 25, the semiconductor device 130 includes the through electrode substrate 1; the first joining portion 121 electrically connected to the pad portion for connecting an element 111 of the through electrode substrate 101; an element 122 electrically connected to the first joining portion 121; a second joining portion 131 electrically connected to the pad portion for connecting a wiring board 109 of the through electrode substrate 101; and a wiring board 132 electrically connected to the second joining portion 131.

For example, when the first joining portion is a solder joining portion, and when the through electrode substrate and the element are joined via the solder joining portion in the reflow process in the semiconductor device production process, the through electrode substrate and the element expand due to heat and then contract due to cooling. In this case, when the difference in thermal expansion coefficients between the through electrode substrate and the element is large, stress will be generated in the first joining portion and the pad portion for connecting an element, likely to cause cracks and disconnections. Furthermore, for example, when semiconductor devices are used in a high-temperature environment, if there is a large difference in the thermal expansion coefficient between the through electrode substrate and the element, stress will be generated in the first joining portion and the pad portion for connecting an element, likely to cause cracks and disconnections.

In contrast to this, in the present embodiment, the through electrode substrate 101 include a glass substrate 102, and the through electrode substrate 101 is used as a so-called glass interposer. Therefore, the difference in thermal expansion coefficients between the glass substrate 102 and the element 122 can be reduced, and stress generation in the first joining portion 121 and the pad portion for connecting an element 111 can be suppressed. Therefore, cracking and disconnection at the first joining portion 121 and the pad portion for connecting an element 111 can be suppressed.

Also, for example, when the second joining portion is a solder joining portion, and when the through electrode substrate and the wiring board are joined via the solder joining portion in the reflow process in the semiconductor device production process, the through electrode substrate and the wiring board expand due to heat and then contract due to cooling. In this case, if there is a large difference in the thermal expansion coefficient between the through electrode substrate and the wiring board, disconnections are likely to occur between the through electrode substrate and wiring board. Furthermore, for example, when semiconductor devices are used in a high-temperature environment, if there is a large difference in the thermal expansion coefficient between the through electrode substrate and the wiring board, stress will be generated in the second joining portion and the pad portion for connecting a wiring board, likely to cause cracks and disconnections.

In contrast to this, in the present embodiment, since the elastic insulating layer 107 having elasticity is disposed, the surface of the elastic insulating layer 107, that is on the side of the pad portion for connecting a wiring board 109 has stretchability. Also, as the surface of the elastic insulating layer 107 that is on the side of the pad portion for connecting a wiring board 109 stretches, the second via 108, disposed in the third through hole 107c of the elastic insulating layer 107, is deformed diagonally. Thereby, the stress due to the difference in thermal expansion coefficients between the through electrode substrate 101 and the wiring board 132 can be relieved by the surface of the elastic insulating layer 107 that is on the side of the pad portion for connecting a wiring board 109 being stretched and the second via 108 being deformed diagonally. Therefore, cracking and disconnection at the second joining portion 131 and the pad portion for connecting a wiring board 109 can be suppressed.

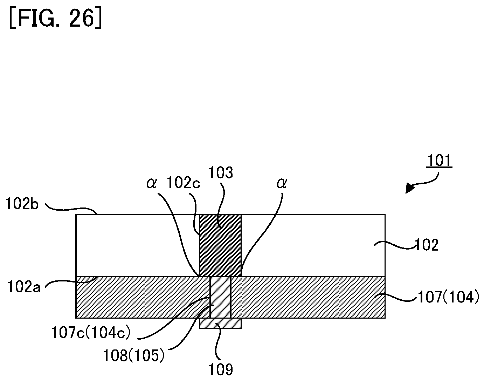

FIG. 26 is a schematic cross-sectional view illustrating another example of a through electrode substrate in the present embodiment. In the through electrode substrate 101 shown in FIG. 26, the elastic insulating layer 107 also serves as the covered insulating layer 104, and the second via 108 also serves as the first via 105. As shown in FIG. 26, the through electrode substrate 101 comprises: a glass substrate 102 including a first surface 102a and a second surface 102b facing the first surface 102a, and including a first through hole 102c; a through electrode 103 disposed in the first through hole 102c of the glass substrate 102; an elastic insulating layer 107 (a covered insulating layer 104 including a second through hole 104c connected to the first through hole 102c) disposed on a first surface 102a side of the glass substrate 102 so as to cover a boundary α between the through electrode 3 and the glass substrate 102, and including a third through hole 107c connected to the first through hole 102c; a second via 108 (first via 105) disposed in the third through hole 107c of the elastic insulating layer 107 (second through hole 104c of the covered insulating layer 104), and electrically connected to the through electrode 3; and a pad portion for connecting a wiring board 109 disposed on the surface of the elastic insulating layer 107 that is opposite side to the glass substrate 102, electrically connected to the second via 108, and electrically connected to a wiring board.

In the present embodiment, the effects similar to that of the through electrode substrate shown in FIG. 23 can also be obtained in the through electrode substrate shown in FIG. 26.

Here, in the production of the semiconductor device in which a through electrode substrate is interspersed between the element and the motherboard, heat treatment such as annealing or reflow soldering is carried out. FIG. 13(a) and FIG. 13(b) are schematic views illustrating the state of the through electrode substrate during heat treatment in the production process of a semiconductor device. In the through electrode substrate including a through electrode 103 filled in the first through hole 102c as shown in FIG. 13(a), during heat treatment, a gap G may occur between the glass substrate 102 and the through electrode 103 due to the difference in thermal expansion coefficient between the glass substrate 102 and the through electrode 103, as shown in FIG. 13(b). Also, during heat treatment, as shown in FIG. 13(b), the difference in thermal expansion coefficient between the glass substrate 102 and the through electrode 103 may cause the through electrode 103 to bulge relative to the first surface or the second surface of the glass substrate 102. Furthermore, during heat treatment, residual moisture or gaseous components such as hydrogen in the material constituting the through electrode 103 may be released, causing the through electrode 103 to be pushed upward. Such gaps or bulges can cause the conductive layer or pad portion located near the boundary between the through electrode and the glass substrate to disconnect. Also, the wire connected to the pad portion may disconnect.

In the present embodiment, for the covered insulating layer 104, resin is used as described later. As shown in FIG. 23, when the covered insulating layer 104 is disposed so as to cover the boundary α between the glass substrate 102 and the through electrode 103, a part of the covered insulating layer 104 is in contact with a part of the through electrode 103. Therefore, even if gas is released from inside the through electrode 103 during heat treatment, that gas can be released to the outside through the covered insulating layer 104. Therefore, it is possible to suppress the occurrence of a bulge in the first conductive layer 106a, which is located near the boundary α, of the first wiring layer 106. Furthermore, since the covered insulating layer 104 is disposed so as to cover the boundary α between the glass substrate 102 and the through electrode 103, even if a gap occurs between the through electrode 103 and the glass substrate 102 during heat treatment, the covered insulating layer 104 can cover the gap between the through electrode 103 and the glass substrate 102, thereby suppressing disconnection of the first conductive layer 106a, which is located on the boundary α, of the first wiring layer 106. Furthermore, even if a step is created between the through electrode 103 and the glass substrate 102 due to gaps or bulges during heat treatment, the covered insulating layer 104 can absorb the step between the through electrode 103 and the glass substrate 102, thereby suppressing the occurrence of a sharp step in the first conductive layer 106a, which is located near the boundary α, of the first wiring layer 106.

Also, in the present embodiment, for the elastic insulating layer 7, elastomer is used as described later. As shown in FIG. 26, when the elastic insulating layer 107 also serves as the covered insulating layer 104, if the elastic insulating layer 107 is disposed so as to cover the boundary α between the glass substrate 102 and the through electrode 103, since a part of the elastic insulating layer 107 is in contact with a part of the through electrode 103, even if gas is released from inside the through electrode 103 during heat treatment, that gas can be released to the outside through the elastic insulating layer 107. Therefore, it is possible to suppress the occurrence of a bulge in the pad portion for connecting a wiring board 109 located near the boundary α. Furthermore, since the elastic insulating layer 107 is disposed so as to cover the boundary α between the glass substrate 102 and the through electrode 103, even if a gap occurs between the through electrode 103 and the glass substrate 102 during heat treatment, the elastic insulating layer 107 can cover the gap between the through electrode 103 and the glass substrate 102, thereby suppressing disconnection of the pad portion for connecting a wiring board 109 located on the boundary α. Furthermore, even if a step is created between the through electrode 103 and the glass substrate 102 due to gaps or bulges during heat treatment, the elastic insulating layer 107 can absorb the step between the through electrode 103 and the glass substrate 102, thereby suppressing the occurrence of a sharp step in the pad portion for connecting a wiring board 109 located near the boundary α.

As described above, since the covered insulating layer is disposed so as to cover the boundary between the glass substrate and through electrode, it is possible to suppress the disconnection of the conductive layer or pad portion located near the boundary between the through electrode and the glass substrate. Therefore, the yield can be increased.

Therefore, in the present embodiment, the connection trustability can be improved.

Each constitution of the through electrode substrate in the present embodiment is hereinafter described.

### 1. Elastic insulating layer

The elastic insulating layer in the present embodiment is disposed on a surface of the covered insulating layer that is opposite to the glass substrate, and including a third through hole passing through the covered insulating layer in the thickness direction.

### (1) Properties of elastic insulating layer

Since the properties of the elastic insulating layer in the present embodiment is similar to the contents in "A. Through electrode substrate intermediate, 1. Elastic insulating layer, (2) Properties of elastic insulating layer" in the first embodiment, the explanation herein is omitted.

Incidentally, the only difference is that, in the elastic insulating layer, the surface on which the Berkovich indenter is pressed is the pad portion for connecting a wiring board side surface of the elastic insulating layer.

### (2) Material of elastic insulating layer

Since the material for the elastic insulating layer in the present embodiment is similar to the contents in "A. Through electrode substrate intermediate, 1. Elastic insulating layer, (3) Material of elastic insulating layer" in the first embodiment, the explanation herein is omitted.

### (3) Convexoconcave shape

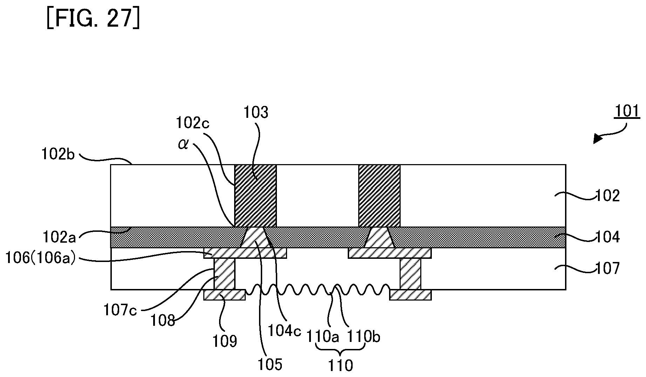

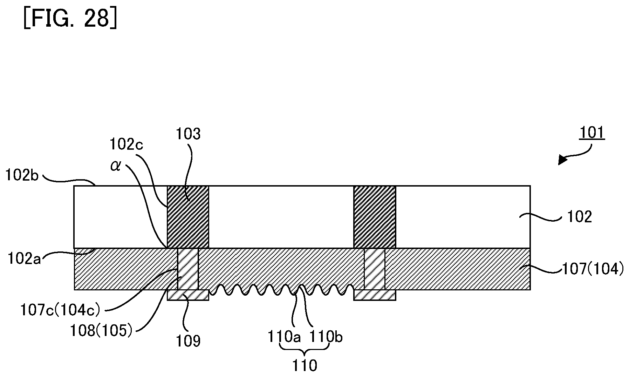

The elastic insulating layer preferably has a convexoconcave shape, including a plurality of convex portions and a plurality of concave portions, on a surface on the side of the pad portion for connecting a wiring board. In FIG. 27 for example, the elastic insulating layer 107 has a convexoconcave shape 110, including a plurality of convex portions 110a and a plurality of concave portions 110b, on the surface on the side of the pad portion for connecting a wiring board 109. Also, in FIG. 28 for example, the elastic insulating layer 107 also serves as the covered insulating layer 104, and the elastic insulating layer 107 has a convexoconcave shape 110, including a plurality of convex portions 110a and a plurality of concave portions 110b, on the surface that is on the side of the pad portion for connecting a wiring board 109. Since the elastic insulating layer 107 has elasticity as well as convexoconcave shape 110 on the pad portion for connecting a wiring board 109 side surface, the stretchability of the pad portion for connecting a wiring board 109 side surface of the elastic insulating layer 107 is improved. The expansion and contraction of the pad portion for connecting a wiring board 109 side surface of the elastic insulating layer 107 further relieves the stress due to the difference in thermal expansion coefficients between the through electrode substrate and the wiring board. Therefore, cracking and disconnection at the second joining portion and the pad portion for connecting a wiring board can be effectively suppressed.

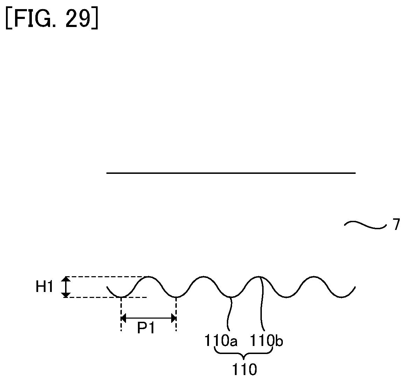

In the convexoconcave shape, the height difference between the adjacent convex portion and concave portion is preferably less than the thickness of the elastic insulating layer. The height difference is, for example, 50 µm or less, may be 15 µm or less, and may be 10 µm or less. When the height difference is too large, the pad portion for connecting a wiring board side surface of the elastic insulating layer may come into contact with the wiring board. Meanwhile, the height difference is, for example, 1 µm or more, may be 3 µm or more, and may be 5 µm or more. When the height difference is too small, the stretchability improving effect due to the convexoconcave shape may not be sufficiently obtained. Specifically, the height difference is 1 µm or more and 50 µm or less, may be 3 µm or more and 15 µm or less, and may be 5 µm or more and 10 µm or less. As shown in FIG. 29 for example, the height difference between the adjacent convex portion and concave portion is indicated with a reference sign H1, and is a distance between the adjacent convex portion 110a and concave portion 110b in the normal line direction to the first surface of the glass substrate.

The height difference between the adjacent convex portion and concave portion is measured based on a cross-sectional image of the through electrode substrate taken with a scanning electron microscope (SEM). The height difference between the adjacent convex portion and concave portion is the arithmetic average value of the height difference at arbitrary 10 locations.

In the convexoconcave shape, the distance between the adjacent convex portions is not particularly limited. The distance is, for example, 2 µm or more, may be 5 µm or more, and may be 6 µm or more. Meanwhile, the distance is, for example, 20 µm or less, may be 10 µm or less, and may be 9 µm or less. Specifically, the distance is 2 µm or more and 20 µm or less, may be 5 µm or more and 10 µm or less, and may be 6 µm or more and 9 µm or less. As shown in FIG. 29 for example, the distance between the adjacent convex portions is indicated with a reference sign P1, and is a distance between the centers of the adjacent convex portions 110a.

The distance between the adjacent convex portions is measured based on a cross-sectional image of the through electrode substrate taken with a scanning electron microscope (SEM). The distance between the adjacent convex portions is the arithmetic average value of the distance at arbitrary 10 locations.

In the convexoconcave shape, the convex portions and concave portions may be arranged regularly, and may be arranged at random.

In the cross-sectional shape of the convex portion, the top portion of the convex portion preferably has a roundness. Examples of the cross-sectional shape of the convex portion may include a semi-circular shape or a semi-ellipse shape. Also, in the cross-sectional shape of the concave portion, the bottom portion of the concave portion preferably has a roundness. Examples of the cross-sectional shape of the concave portion may include a semi-circular shape or a semi-ellipse shape. When the pad portion for connecting a wiring board is disposed on the convexoconcave shape of the elastic insulating layer, disconnection of the pad portion for connecting a wiring board can be suppressed if the convex portion and the concave portion have the shapes described above.

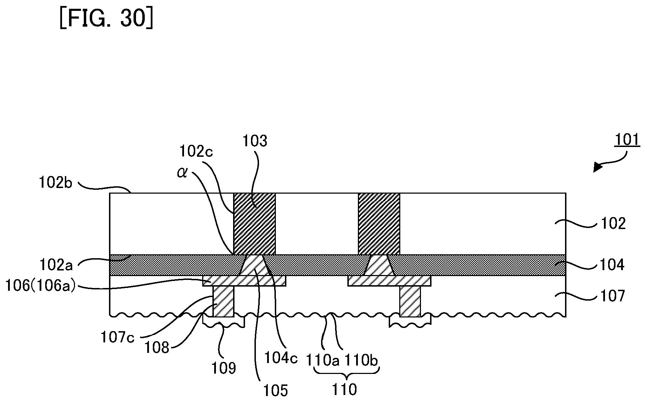

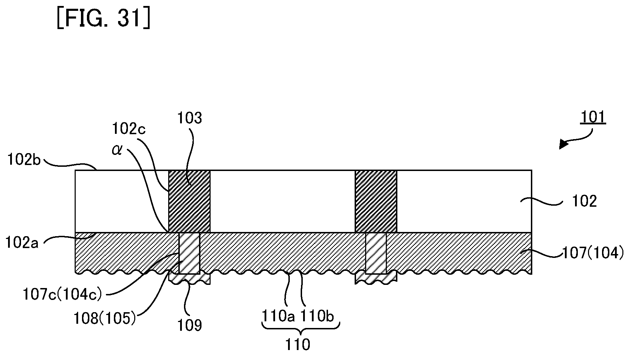

In the pad portion for connecting a wiring board side surface of the elastic insulating layer, the location of the convexoconcave shape is not particularly limited. In the pad portion for connecting a wiring board side surface of the elastic insulating layer, the convexoconcave shape may be disposed on the entire surface, and the convexoconcave shape may be partially disposed. In FIG. 27 and FIG. 28 for example, in the pad portion for connecting a wiring board 109 side surface of the elastic insulating layer 107, the convexoconcave shape 110 is partially disposed. In FIG. 30 and FIG. 31 for example, in the pad portion for connecting a wiring board 109 side surface of the elastic insulating layer 107, the convexoconcave shape 110 is disposed on the entire surface. In particular, as shown In FIG. 27, FIG. 28, FIG. 30 and FIG. 31, in the pad portion for connecting a wiring board 109 side surface of the elastic insulating layer 107, the convexoconcave shape 110 is preferably disposed at least in the region between the adjacent pad portions for connecting a wiring board 109. As described above, the stress, due to the difference in thermal expansion coefficients between the through electrode substrate and the wiring board, can further be relieved by the convexoconcave shape. Therefore, in the semiconductor device including the through electrode substrate, cracking and disconnection at the second joining portion and the pad portion for connecting a wiring board can be effectively suppressed.

### (4) Structure of elastic insulating layer

In the present embodiment, as described above, the elastic insulating layer may or may not also serve as the covered insulating layer. Among them, it is preferable that the elastic insulating layer does not also serve as the covered insulating layer, that is, the elastic insulating layer and the covered insulating layer are disposed respectively. The covered insulating layer is described later.

The thickness of the elastic insulating layer is, for example, 5 µm or more, may be 15 µm or more, and may be 50 µm or more. When the thickness of the elastic insulating layer is in the above range, the stretchability of the pad portion for connecting a wiring board side surface of the elastic insulating layer is improved. Meanwhile, the thickness of the elastic insulating layer is, for example, 200 µm or less, may be 100 µm or less, and may be 60 µm or less. When the thickness of the elastic insulating layer is too thick, the thickness of the through electrode substrate as a whole may become thick. Specifically, the thickness of the elastic insulating layer is 5 µm or more and 200 µm or less, may be 15 µm or more and 100 µm or less, and may be 50 µm or more and 60 µm or less.

In the present descriptions, the thickness of each layer is measured based on a cross-sectional image of the through electrode substrate taken with a scanning electron microscope (SEM). The thickness is the arithmetic average value of the thickness at arbitrary 5 locations.

### (5) Method for forming elastic insulating layer

The elastic insulating layer can be formed by applying the material described above. Also, the method for forming the third through hole is appropriately selected according to the material of the elastic insulating layer, and examples thereof may include photolithography method, laser processing, and shaping using a mold. In the case of photolithography method, the material of the elastic insulating layer may be a photosensitive material, and the resist pattern may be formed on the elastic insulating layer. In the case of shaping using a mold, a mold may be used to form a convexoconcave shape on the surface of the elastic insulating layer by shaping, and at the same time, the third through hole may be formed in the elastic insulating layer by shaping using this mold. Also, examples of the method for forming a convexoconcave shape may include a shaping using a mold.

### 2. Second via

The second via in the present embodiment is disposed in the third through hole of the elastic insulating layer, and is to be electrically connected to the first via and the pad portion for connecting a wiring board.

The material for the second via is not particularly limited as long as it is a material having conductivity, and conductive material used for general vias can be used, and is appropriately selected according to the aspect or forming method of the via.

Methods for forming a general via can be used for the method for forming the second via, and it is appropriately selected according to the aspect of the via. In the method for forming the second via, a third through hole is firstly formed in the elastic insulating layer, and then a second via is formed in the third through hole in the elastic insulating layer. Examples of the method for forming a via in the third through hole of the elastic insulating layer may include PVD method such as vacuum deposition and sputtering; CVD method; and plating method. A conductive material may be filled into the third through hole of the elastic insulating layer to form a via, and at the same time, the pad portion for connecting a wiring board may be formed with this conductive material. In the case of the plating method, the third through hole is firstly formed in the elastic insulating layer, then a seed layer is formed on the entire surface of the elastic insulating layer by, for example, sputtering, then a photoresist layer is formed on the seed layer, then the photoresist layer is patterned to have an aperture portion for the pad portion for connecting a wiring board, and then the aperture portion of the photoresist layer is subjected to electrolytic plating to form a plating layer, thereby simultaneously forming the second via and the pad portion for connecting a wiring board. In this case, the second via and the pad portion for connecting a wiring board include a seed layer and a plating layer.

### 3. Covered insulating layer

The covered insulating layer in the present embodiment is disposed so as to cover at least the boundary between the through electrode and glass substrate, connected to the first through hole of the glass substrate, and includes a second through hole passing through the covered insulating layer in the thickness direction.

The covered insulating layer is preferably in direct contact with the glass substrate.

The material of the covered insulating layer is preferably insulating resin. Examples of the insulating resin may include polyimide, polyamide, polyamideimide, polyethylene terephthalate, polyethylene naphthalate, polyphenylene sulfide, polyetheretherketone, polyethersulfone, polycarbonate, polyetherimide, epoxy resin, phenolic resin, polyphenylene ether, acrylic resins, polyolefins, polycycloolefins, and liquid crystalline polymer compounds. Examples of the polyolefin may include polyethylene, and polypropylene. Examples of the polycycloolefin may include polynorbornene.

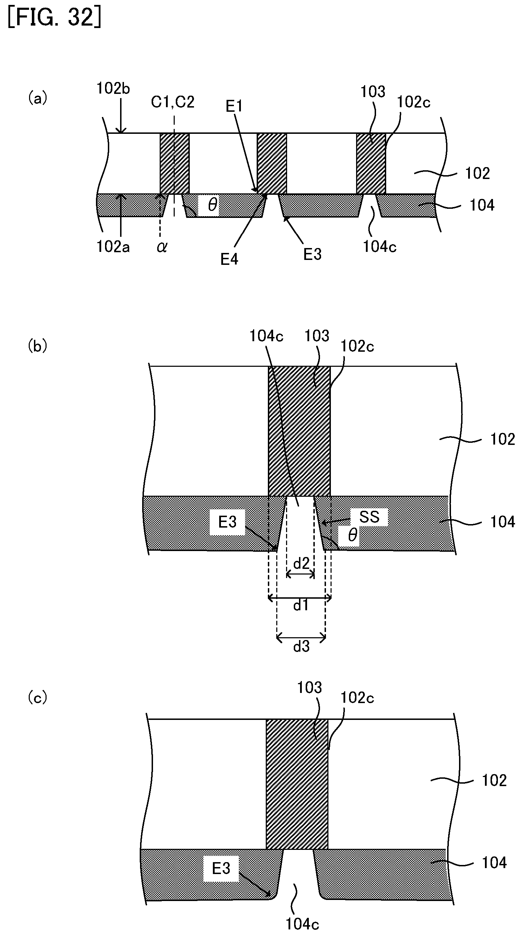

FIG. 32(a) to FIG. 32(c) are schematic cross-sectional views illustrating an example of an arrangement of a first through hole of a glass substrate and a covered insulating layer of a through electrode substrate. In FIG. 32(a) to FIG. 32(c), the structures other than the glass substrate and the covered insulating layer are omitted. As shown in FIG. 32(a), the second through hole 104c in the covered insulating layer 104 is connected to the first through hole 102c of the glass substrate 102. It is preferable that the central axis C1 of the first through hole 102c of the glass substrate 102 approximately coincides with the central axis C2 of the second through hole 104c of the covered insulating layer 104.

Also, it is preferable that the glass substrate 102 side aperture diameter d2 of the second through hole 104c of the covered insulating layer 104 is smaller than the first surface 102a side aperture diameter d1 of the first through hole 102c of the glass substrate 102. The ratio d2/d1 is, for example, 0.5 or more and less than 1.0, and may be 0.6 or more and 0.9 or less.

The first surface 102a side aperture diameter d1 of the first through hole 102c of the glass substrate 102 is, for example, 50 µm or more and 100 µm or less, and may be 60 µm or more and 90 µm or less. Meanwhile, the glass substrate 102 side aperture diameter d2 of the second through hole 104c of the covered insulating layer 104 is not particularly limited, and is, for example, 40 µm or more and 85 µm or less, and may be 50 µm or more and 80 µm or less.

Also, the rim portion E4 of the aperture of the second through hole 104c on the glass substrate 102 side surface of the covered insulating layer 104 is preferably disposed on the inner side than the rim portion E1 of the aperture of the first through hole 102c on the first surface 102c of the glass substrate 102. Since the covered insulating layer 104 including such the second through hole 104c is disposed, the boundary α between the glass substrate 102 and the through electrode 103 can be covered by the covered insulating layer 104.

As shown in FIG. 32(b) for example, the cross-sectional shape of the second through hole 104c of the covered insulating layer 104 is preferably a reverse tapered shape wherein the glass substrate 102 side aperture diameter d2 of the second through hole 104c is smaller than the aperture diameter d3 of the second through hole 104c that is opposite to the glass substrate 102. When the second through hole 104c has the reverse taper shape, the angle θ between the side wall SS of the second through hole 104c and the surface of the covered insulating layer 104 that is opposite to the glass substrate 102 is obtuse in the cross-sectional view in the thickness direction of the covered insulating layer 104. Therefore, even if the through electrode 103 expands and swells, the stress can be suppressed from being concentrated near the rim portion E3 of the aperture of the second through hole 104c on the surface of the covered insulating layer 104 that is opposite side to the glass substrate 102. Therefore, disconnection of the pad portion or conductive layer disposed on the surface of the covered insulating layer that is opposite side to the glass substrate can be suppressed.

The angle θ is not particularly limited, and for example, it may be more than 90 degrees and 130 degrees or less, and may be 100 degrees or more and 120 degrees or less. When angle θ is in the above range, disconnection of the pad portion or conductive layer disposed on the surface of the covered insulating layer, that is opposite side to the glass substrate, can be further suppressed. Meanwhile, when the angle θ is too large, the aperture diameter d3 of the second through hole 104c, that is opposite side to the glass substrate 102, will be large, and it may not be suitable for high-density mounting.

As shown in FIG. 32(c) for example, in the cross-sectional view in the thickness direction of the covered insulating layer 104, the rim portion E3 of the aperture of the second through hole 104c, on the surface of the covered insulating layer 104 that is opposite to the glass substrate 102, preferably includes a curved surface. When the rim portion E3 includes a curved surface, disconnection of the pad portion or conductive layer disposed on the surface of the covered insulating layer, that is opposite side to the glass substrate, can be further suppressed.

The method for forming the second through hole is appropriately selected according to the material of the covered insulating layer, and examples thereof may include photolithography method, and laser processing. In the case of photolithography method, the material of the covered insulating layer may be a photosensitive material, and the resist pattern may be formed on the covered insulating layer.

### 4. First via

The first via in the present embodiment is disposed in the second through hole of the covered insulating layer, and is electrically connected to the through electrode, second via and the pad portion for connecting a wiring board. The first via is preferably in direct contact with the through electrode.

The first via may be a via that fills the second through hole in the covered insulating layer, a so-called filled via, and may be a via disposed only on the side wall of the second through hole of the covered insulating layer, a so-called conformal via.

The material of the first via is similar to the material of the through electrode described later. The material of the through electrode and the material of the first via are preferably the same.

The first via can be formed, for example, by electrolytic plating. When the conductive layer of the first wiring layer described later is disposed on the surface of the covered insulating layer that is opposite side to the glass substrate, the first via is preferably formed at the same time as the conductive layer of the first wiring layer. Also, when the elastic insulating layer also serves as the covered insulating layer, the first via can be formed at the same time as the pad portion for connecting a wiring board.

### 5. Glass substrate

The glass substrate in the present embodiment includes a first surface and a second surface facing the first surface, and includes a first through hole passing through the glass substrate in the thickness direction.

Since the glass substrate has good flatness, fine wiring can be formed with a narrow pitch. Also, since the thermal expansion coefficient of the glass substrate can be adjusted according to the composition thereof, the glass substrate with preferable thermal expansion coefficient can be selected.

Examples of the glass used for the glass substrate may include alkaline-free glass, and quartz.

The thermal expansion coefficient of the glass substrate is preferably, for example, 2 ppm/°C or more and 9 ppm/°C or less.

When the thermal expansion coefficient of the glass substrate is in the above range, the difference between the thermal expansion coefficient of the glass substrate and the thermal expansion coefficient of the element can be sufficiently small.

In the present descriptions, the thermal expansion coefficient is the linear expansion coefficient. The thermal expansion coefficient is measured by a thermomechanical analysis (TMA) according to JIS R3102:1995.

The plan-view shape of the glass substrate is not particularly limited, and examples may include rectangular shapes such as oblong figure and square shape.

The plan-view shape of the first through hole of the glass substrate is, for example, approximate circular shape. Also, examples of the cross-sectional shape of the first through hole 102c of the glass substrate 102 may include a straight shape as shown in FIG. 23; a reverse tapered shape whose aperture diameter on the first surface 102a side is larger than the aperture diameter on the second surface 102b side as shown in FIG. 12(a); a forward tapered shape whose aperture diameter on the first surface 102a side is smaller than the aperture diameter on the second surface 102b side as shown in FIG. 12(b); an hourglass shape with the smallest diameter portion at a predetermined location between the first surface 102a and the second surface 102b as shown in FIG. 12(c); and a bowing shape with the largest diameter at a predetermined location between the first surface 102a and the second surface 102b as shown in FIG. 12(d). FIG. 12(a) to FIG. 12(d) are schematic cross-sectional views illustrating an example of a cross-sectional shape of the first through hole of the glass substrate. The cross-sectional shape of the first through hole of the glass substrate is preferably either one of the reverse tapered shape or an hourglass shape. Also, in each cross-sectional shape of the first through hole of the glass substrate, it is preferable that the rim portion E1 of the aperture of the first through hole 102c on the first surface 102a of the glass substrate 102, the rim portion E2 of the aperture of the first through hole 102c on the second surface 102b of the glass substrate 102, and the minimum portion and maximum portion of the diameter of the first through hole 102c of the glass substrate 102 include a curved surface. The disconnection in the through electrode and the via or conductive layer in contact with the through electrode can be suppressed.

The thickness of the glass substrate is, for example, 100 µm or more, may be 200 µm or more, may be 300 µm or more, and may be 400 µm or more. When the thickness of the glass substrate is in the above range, the deflection of the glass substrate can be suppressed from growing. Therefore, it is possible to suppress difficulties in handling the glass substrate during the production process, and prevent the glass substrate from warping due to internal stresses of thin films disposed on the first surface or second surface of the glass substrate. Meanwhile, the thickness of the glass substrate is, for example, 2000 µm or less, may be 1000 µm or less, and may be 800 µm or less. When the thickness of the glass substrate is in the above range, the time required to form a through hole in the glass substrate can be shortened. Specifically, the thickness of the glass substrate is 100 µm or more and 2000 µm or less, may be 200 µm or more and 1000 µm or less, may be 300 µm or more and 1000 µm or less, and may be 400 µm or more and 800 µm or less.

### 6. Through electrode

The through electrode in the present embodiment is disposed in the first through hole of the glass substrate.

The aspect of the through electrode is not particularly limited as long as the first surface and the second surface of the glass substrate can be electrically connected. The aspect of the through electrode may be, for example, a through electrode that fills a first through hole of the glass substrate, a so-called filled via, and may be a through electrode disposed only on the side wall of the first through hole of the glass substrate, a so-called conformal via. Also, when the through electrode is a conformal via, a hollow portion may be disposed in the first through hole, and the through hole may be filled with a resin portion. In particular, the through electrode is preferably a so-called filled via, wherein the first through hole is filled with a conductive material, from the viewpoint of fully exhibiting the effects of the present embodiment, since the thermal expansion and gas-related problems of the through electrode described above tend to occur.

Since other points about the through electrode are similar to the contents in "A. Through electrode substrate intermediate, 6. Through electrode" in the first embodiment described above, the explanation herein is omitted.

### 7. Pad portion for connecting wiring board

The pad portion for connecting a wiring board in the present embodiment is disposed on a surface of the elastic insulating layer that is opposite side to the glass substrate, and to be electrically connected to the second via and wiring board. The pad portion for connecting a wiring board is connected directly to the second via, not via wiring. In other words, the pad portion for connecting a wiring board is in direct contact with the second via. Also, as will be described later, since the pad portion for connecting a wiring board of the through electrode substrate in the present embodiment and the wiring board are electrically connected via the second joining portion, no wiring is required. In other words, on the surface of the elastic insulating layer that is opposite side to the glass substrate, there is neither wire for electrically connecting the pad portion for connecting a wiring board and the second via, nor wire for electrically connecting the pad portion for connecting a wiring board and the wiring board.

The material of the pad portion for connecting a wiring board is not particularly limited as long as it is a material having conductivity, and conductive material used for general wires can be used. Examples of the conductive material may include metals such as copper, molybdenum, titanium, tungsten, tantalum, aluminum, gold, silver, nickel and palladium; alloys including at least one metal selected from these metals; or metal oxides such as indium tin oxide (ITO) and indium zinc oxide (IZO). Among them, copper is preferably used.

The plan-view shape of the pad portion for connecting a wiring board is not particularly limited, and examples thereof may include a circular shape, an oval shape, a square shape, and a rectangular shape.

The thickness of the pad portion for connecting a wiring board is similar to the thickness of typical wires. The thickness of the pad portion for connecting a wiring board is, for example, 0.05 µm or more and 100 µm or less, may be 0.1 µm or more and 50 µm or less, and may be 0.2 µm or more and 10 µm or less. Thereby, sufficient conductivity can be obtained.

General method for forming wiring can be used as the method for forming a pad portion for connecting a wiring board, and examples thereof may include methods wherein a conductive film is formed by a dry film-forming method such as CVD method or PVD method such as sputtering method, or by a plating method, and then, the conductive film is patterned by photolithography method.

Also, the pad portion for connecting a wiring board is preferably disposed regularly in a plan view. As a result, in the production process of a semiconductor device using the through electrode substrate, the heat history applied to the second joining portion, that electrically connects the through electrode substrate and wiring board, will be uniform. As a result, the yield increases.

### 8. First wiring layer

The through electrode substrate in the present embodiment may include a first wiring layer disposed between the covered insulating layer and elastic insulating layer, and electrically connected to the first via and the second via.

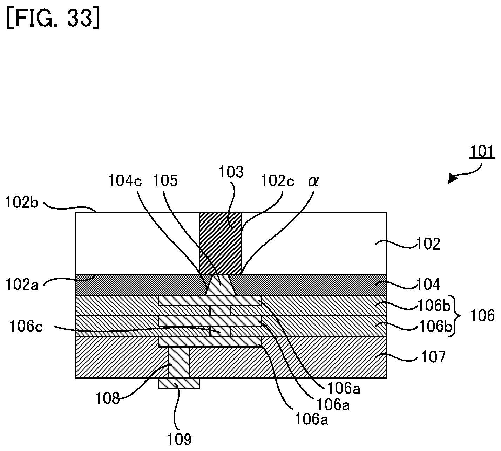

The first wiring layer includes at least a first conductive layer. The first wiring layer may further include the first interlayer insulating layer and fourth via. The first conductive layer may be 1 layer, and may be 2 layers or more. When the first wiring layer includes 2 or more first conductive layers, each first conductive layer is stacked in the thickness direction via the first interlayer insulating layer. Also, each first conductive layer is electrically connected via the fourth via. For example, in FIG. 33, the first wiring layer 106 includes, in order from the glass substrate 2 side, the first conductive layer 106a, first interlayer insulating layer 106b, first conductive layer 106a, first interlayer insulating layer 106b, and first conductive layer 106a; and each first conductive layer 106a is electrically connected by the fourth via 106c.

The material of the first conductive layer is not particularly limited as long as it is a material having conductivity, and conductive material used for general wires of interposers can be used. Examples of the conductive material may include metal materials such as metals and metal oxides; conductive resins including conductive fillers and resins; and conductive polymers.

The thickness of the first conductive layer is, for example, 0.1 µm or more, may be 0.5 µm or more, may be 1 µm or more, may be 3 µm or more, and may be 5 µm or more. Meanwhile, the thickness of the first conductive layer is, for example, 20 µm or less, and may be 15 µm or less. The thickness of the first conductive layer is, for example, 0.1 µm or more and 20 µm or less, may be 0.5 µm or more and 15 µm or less, may be 1 µm or more and 15 µm or less, may be 3 µm or more and 15 µm or less, and may be 5 µm or more and 15 µm or less. For example, when the first conductive layer is formed by the sputtering method, a relatively thin first conductive layer can be obtained. Also, a relatively thick first conductive layer can be obtained when the first conductive layer is formed by, for example, plating methods.

The method for forming the first conductive layer may be an additive method, and may be a subtractive method. In the additive method, for example, a resist pattern is formed by photolithography method, and a patterned wiring layer is obtained by plating the portion exposed from the resist pattern. When the electrolytic plating method is used, a conductive film may be formed on the first surface of the glass substrate or on the surface of the first interlayer insulating layer that is opposite to the glass substrate prior to the formation of the resist pattern. In the subtractive method, for example, a resist pattern is formed on a conductive film formed on the entire surface of the first surface side of the glass substrate, and the portion exposed from the resist pattern is etched to obtain a patterned first conductive layer.

The material of the first interlayer insulating layer is preferably insulating resin. Examples of the insulating resin may include polyimide, polyamide, polyamideimide, polyethylene terephthalate, polyethylene naphthalate, polyphenylene sulfide, polyetheretherketone, polyethersulfone, polycarbonate, polyetherimide, epoxy resin, phenolic resin, polyphenylene ether, acrylic resins, polyolefins, polycycloolefins, and liquid crystalline polymer compounds. Examples of the polyolefin may include polyethylene, and polypropylene. Examples of the polycycloolefin may include polynorbornene.

The thickness of the first interlayer insulating layer is, for example, 1.5 µm or more, and may be 2.5 µm or more. Meanwhile, the thickness of the first interlayer insulating layer is, for example, 6 µm or less. The thickness of the first interlayer insulating layer is, for example, 1.5 µm or more and 6 µm or less, and may be 2.5 µm or more and 6 µm or less.

Examples of the method for forming a first interlayer insulating layer may include a photolithography method and a printing method.

The fourth via is similar to the second via described above.

### 9. Second covered insulating layer and third via

The through electrode substrate in the present embodiment preferably includes a second covered insulating layer disposed on a second surface side of the glass substrate so as to cover at least a boundary between the through electrode and the glass substrate, and including a fourth through hole connected to the first through hole; and a third via disposed in the fourth through hole of the second covered insulating layer, and electrically connected to the through electrode.

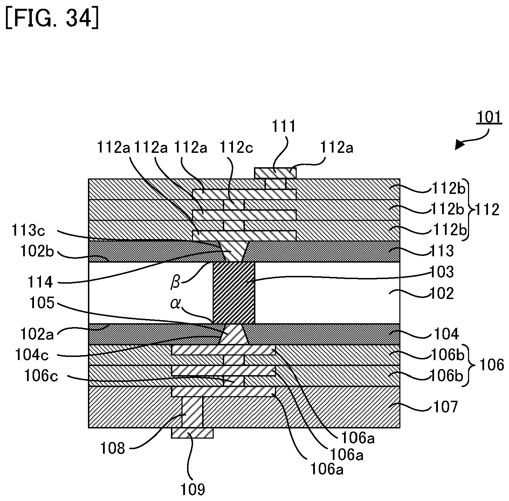

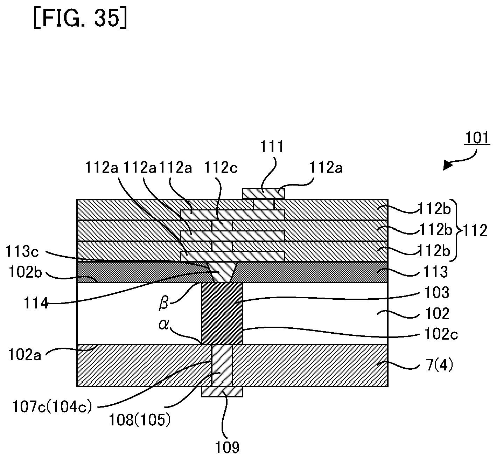

In FIG. 34 and FIG. 35, the through electrode substrate 1 includes a second covered insulating layer 113 disposed on a second surface 102b side of the glass substrate 102 so as to cover at least a boundary β between the through electrode 103 and the glass substrate 102, and including a fourth through hole 113c connected to the first through hole 102c; and a third via 114 disposed in the fourth through hole 113c of the second covered insulating layer 113, electrically connected to the through electrode 103, and electrically connected to the pad portion for connecting an element 111. In FIG. 34 and FIG. 35, the second wiring layer 112 including a second conductive layer 112a, second interlayer insulating layer 112b, and fifth via 112c is disposed on the surface of the second covered insulating layer 113 that is opposite side to the glass substrate 102, the third via 114 is electrically connected to the pad portion for connecting an element 111 via the second conductive layer 112a and fifth via 112c of the second wiring layer 112.

The second covered insulating layer has similar effect to the covered insulating layer described above. The second covered insulating layer and third via are respectively similar to the covered insulating layer and first via described above.

### 10. Second wiring layer

The through electrode substrate in the present embodiment may include a second wiring layer disposed on the second surface side of the glass substrate, and electrically connected to the through electrode.

The second wiring layer includes at least a second conductive layer. The second wiring layer may further include the second interlayer insulating layer and fifth via. The second conductive layer may be 1 layer, and may be 2 layers or more. When the second wiring layer includes 2 or more second conductive layers, each second conductive layer is stacked in the thickness direction via the second interlayer insulating layer. Also, each second conductive layer is electrically connected via the fifth via. For example, in FIG. 34 and FIG. 35, the second wiring layer 112 includes, in order from the glass substrate 102 side, the second conductive layer 112a, second interlayer insulating layer 112b, second conductive layer 112a, second interlayer insulating layer 112b, second conductive layer 112a, second interlayer insulating layer 112b, and second conductive layer 112a; and each second conductive layer 112a is electrically connected by the fifth via 112c. The second conductive layer 112a, which is located on the surface of the second wiring layer 112 that is opposite side to the glass substrate 102, includes a pad portion for connecting an element 111.

The second conductive layer and the second interlayer insulating layer in the second wiring layer are similar to the first conductive layer and the first interlayer insulating layer in the first wiring layer above.

The plan-view shape of the pad portion for connecting an element is similar to the plan-view shape of the pad portion for connecting a wiring board above.

### B. Through electrode substrate provided with element

The through electrode substrate provided with an element in the present embodiment includes the through electrode substrate described above, and an element mounted on the through electrode substrate.

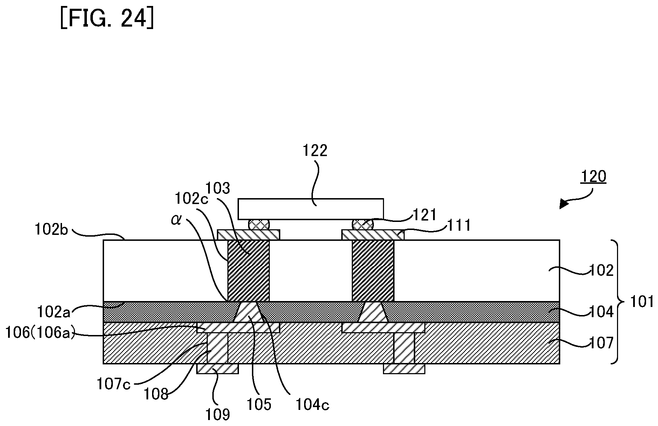

FIG. 24 is a schematic cross-sectional view illustrating an example of a through electrode substrate provided with an element in the present embodiment. As shown in FIG. 24, the through electrode substrate provided with an element 20 includes the through electrode substrate 101 described above; the first joining portion 121 electrically connected to the pad portion for connecting an element 111 of the through electrode substrate 101; and an element 122 electrically connected to the first joining portion 121.

Since the through electrode substrate provided with an element in the present embodiment includes the through electrode substrate described above, disconnection can be suppressed and connection reliability can be improved.

Each constitution of the through electrode substrate provided with an element in the present embodiment is hereinafter described.

### 1. Through electrode substrate

Since the through electrode substrate is described in the section "A. Through electrode substrate" above in detail, the description herein is omitted.

### 2. Element

Since the element in the present embodiment is similar to the contents in "C. Through electrode substrate provided with an element, 2. Element" in the first embodiment described above, the explanation herein is omitted.

### C. Semiconductor device

The semiconductor device in the present embodiment includes the through electrode substrate provided with an element described above; and a wiring board electrically connected to the pad portion for connecting a wiring board of the through electrode substrate.

FIG. 25 is a schematic cross-sectional view illustrating an example of a semiconductor device in the present embodiment. As shown in FIG. 25, the semiconductor device 130 includes the through electrode substrate 101 described above; a first joining portion 121 electrically connected to the pad portion for connecting an element 111 of the through electrode substrate 101; an element 122 electrically connected to the first joining portion 121; a second joining portion 131 electrically connected to the pad portion for connecting a wiring board 109 of the through electrode substrate 1; and a wiring board 132 electrically connected to the second joining portion 131.

Since the semiconductor device in the present embodiment includes the through electrode substrate provided with an element described above, disconnection can be suppressed and connection reliability can be improved.

Each constitution of the semiconductor device in the present embodiment is hereinafter described.

### 1. Through electrode substrate provided with element

Since the through electrode substrate provided with an element is described in the section "B. Through electrode substrate provided with element" above in detail, the description herein is omitted.

### 2. Wiring board

For the wiring board in the present embodiment, general wiring boards can be used.

The wiring board is electrically connected to the pad portion for connecting a wiring board of the through electrode substrate via the second joining portion.

The material of the second joining portion is similar to the material of the first joining portion described above.

### 3. Use application

The use application of the semiconductor device in the present embodiment is not particularly limited, and examples thereof may include laptop personal computers, tablet terminals, mobile phones, smartphones, digital video cameras, digital cameras, digital clocks, and servers.

Incidentally, the present disclosure is not limited to the embodiments. The embodiments are exemplification, and any other variations are intended to be included in the technical scope of the present disclosure if they have substantially the same constitution as the technical idea described in the claim of the present disclosure and offer similar operation and effect thereto.

The present disclosure provides the following inventions.
[1] A through electrode substrate intermediate comprising:
   a glass substrate including a first surface and a second surface facing the first surface, and including a through hole;
   a through electrode disposed in the through hole of the glass substrate;
   an elastic insulating layer disposed on a first surface side of the glass substrate;
   a via passing through the elastic insulating layer, and electrically connected to the through electrode;
   a pad portion for a via disposed on a surface of the elastic insulating layer that is opposite side to the glass substrate, and electrically connected to the via; and
   a pad portion for connecting a wiring board disposed on a surface of the elastic insulating layer that is opposite side to the glass substrate, and to be electrically connected to a wiring board, wherein
   the elastic insulating layer has a convexoconcave shape, including a plurality of convex portions and a plurality of concave portions, on a surface that is on a side of the pad portion for a via and the pad portion for connecting a wiring board.
[2] The through electrode substrate intermediate according to [1], further comprising:
   a covered insulating layer disposed between the glass substrate and the elastic insulating layer so as to cover at least a boundary between the through electrode and the glass substrate, and including a second through hole connected to the through hole; and
   a second via disposed in the second through hole of the covered insulating layer, electrically connected to the through electrode, and electrically connected to the pad portion for a via.
[3] The through electrode substrate intermediate according to [2], wherein the elastic insulating layer also serves as the covered insulating layer, and the via also serves as the second via.
[4] The through electrode substrate intermediate according to any one of [1] to [3], further comprising a pad portion for connecting an element disposed on a second surface side of the glass substrate, electrically connected to the through electrode, and to be electrically connected to an element.
[5] The through electrode substrate intermediate according to any one of [1] to [4], further comprising:
   a second covered insulating layer disposed on a second surface side of the glass substrate so as to cover at least a boundary between the through electrode and the glass substrate, and including a third through hole connected to the through hole; and
   a third via disposed in the third through hole of the second covered insulating layer, and electrically connected to the through electrode.
[6] A through electrode substrate comprising:
   the through electrode substrate intermediate according to any one of [1] to [5]; and
   a bellows wiring layer disposed on an elastic insulating layer side surface of the through electrode substrate intermediate, including a bellows-shaped portion including a plurality of mountain portions and a plurality of valley portions, and electrically connecting the pad portion for a via and the pad portion for connecting a wiring board.
[7] A through electrode substrate provided with an element comprising:
   the through electrode substrate according to [6]; and an element mounted on the through electrode substrate.
[8] A semiconductor device comprising: the through electrode substrate provided with an element according to [7]; and a wiring board electrically connected to the pad portion for connecting a wiring board of the through electrode substrate.
[9] A through electrode substrate comprising:
   a glass substrate including a first surface and a second surface facing the first surface, and including a first through hole;
   a through electrode disposed in the first through hole of the glass substrate;
   a covered insulating layer disposed on a first surface side of the glass substrate so as to cover at least a boundary between the through electrode and the glass substrate, and including a second through hole connected to the first through hole;
   a first via disposed in the second through hole of the covered insulating layer, and electrically connected to the through electrode;
   an elastic insulating layer disposed on a surface of the covered insulating layer that is opposite to the glass substrate, and including a third through hole;
   a second via disposed in the third through hole of the elastic insulating layer, and electrically connected to the first via; and
   a pad portion for connecting a wiring board disposed on a surface of the elastic insulating layer that is opposite side to the covered insulating layer, electrically connected to the second via, and to be electrically connected to a wiring board.
[10] The through electrode substrate according to [9], wherein the elastic insulating layer has a convexoconcave shape, including a plurality of convex portions and a plurality of concave portions, on a surface on a side of the pad portion for connecting a wiring board.
[11] The through electrode substrate according to [9] or [10], wherein a cross-sectional shape of the second through hole, in a thickness direction of the covered insulating layer, is a reverse tapered shape.
[12] The through electrode substrate according to any one of [9] to [11], wherein a rim portion of an aperture of the second through hole, at a surface of the covered insulating layer that is opposite to the glass substrate, has a curved surface in a cross-sectional view in a thickness direction of the covered insulating layer.
[13] The through electrode substrate according to any one of [9] to [12], wherein the elastic insulating layer also serves as the covered insulating layer, and the second via also serves as the first via.
[14] The through electrode substrate according to any one of [9] to [13], further comprising a pad portion for connecting an element disposed on a second surface side of the glass substrate, electrically connected to the through electrode, and to be electrically connected to an element.
[15] The through electrode substrate according to any one of [9] to [14], further comprising:
   a second covered insulating layer disposed on a second surface side of the glass substrate so as to cover at least a boundary between the through electrode and the glass substrate, and including a fourth through hole connected to the first through hole; and
   a third via disposed in the fourth through hole of the second covered insulating layer, and electrically connected to the through electrode.
[16] A through electrode substrate provided with an element comprising:
   the through electrode substrate according to any one of [9] to [15]; and
   an element mounted on the through electrode substrate.
[17] A semiconductor device comprising:
   the through electrode substrate provided with an element according to [16]; and
   a wiring board electrically connected to the pad portion for connecting a wiring board of the through electrode substrate.

### Reference Signs List

- 1: through electrode substrate intermediate
- 2, 102: glass substrate
- 2a, 102a: first surface of glass substrate
- 2b, 102b: second surface of glass substrate
- 3, 103: through electrode
- 4: first wiring layer
- 4a: conductive layer
- 5: elastic insulating layer
- 6: via
- 7: pad portion for a via
- 8: pad portion for connecting a wiring board
- 9: convexoconcave shape
- 9a: convex portion
- 9b: concave portion
- 11: pad portion for connecting an element
- 15: covered insulating layer
- 16: second via
- 17: second covered insulating layer
- 18: third via
- 20: through electrode substrate
- 21: bellows-shaped portion
- 21a: mountain portion
- 21b: valley portion
- 22: bellows wiring layer
- 30: through electrode substrate provided with an element
- 31: first joining portion
- 32: element
- 40: semiconductor device
- 41: second joining portion
- 42: wiring board
- 101: through electrode substrate
- 104: covered insulating layer
- 104c: second through hole
- 105: first via
- 106: first wiring layer
- 106a: first conductive layer
- 106b: first interlayer insulating layer
- 106c: fourth via
- 107: elastic insulating layer
- 107c: third through hole
- 108: second via
- 109: pad portion for connecting a wiring board
- 110: convexoconcave shape
- 110a: convex portion
- 110b: concave portion
- 111: pad portion for connecting an element
- 112: second wiring layer
- 112a: second conductive layer
- 112b: second interlayer insulating layer
- 112c: fifth via
- 113: second covered insulating layer
- 113c: fourth through hole
- 114: third via
- 120: through electrode substrate provided with an element
- 121: first joining portion
- 122: element
- 130: semiconductor device
- 131: second joining portion
- 132: wiring board

## Claims

1. A through electrode substrate intermediate comprising:
a glass substrate including a first surface and a second surface facing the first surface, and including a through hole;
a through electrode disposed in the through hole of the glass substrate;
an elastic insulating layer disposed on a first surface side of the glass substrate;
a via passing through the elastic insulating layer, and electrically connected to the through electrode;
a pad portion for a via disposed on a surface of the elastic insulating layer that is opposite side to the glass substrate, and electrically connected to the via; and
a pad portion for connecting a wiring board disposed on a surface of the elastic insulating layer that is opposite side to the glass substrate, and to be electrically connected to a wiring board, wherein
the elastic insulating layer has a convexoconcave shape, including a plurality of convex portions and a plurality of concave portions, on a surface that is on a side of the pad portion for a via and the pad portion for connecting a wiring board.

2. The through electrode substrate intermediate according to claim 1, further comprising:
a covered insulating layer disposed between the glass substrate and the elastic insulating layer so as to cover at least a boundary between the through electrode and the glass substrate, and including a second through hole connected to the through hole; and
a second via disposed in the second through hole of the covered insulating layer, electrically connected to the through electrode, and electrically connected to the pad portion for a via.

3. The through electrode substrate intermediate according to claim 2, wherein the elastic insulating layer also serves as the covered insulating layer, and the via also serves as the second via.

4. The through electrode substrate intermediate according to claim 1, further comprising a pad portion for connecting an element disposed on a second surface side of the glass substrate, electrically connected to the through electrode, and to be electrically connected to an element.

5. The through electrode substrate intermediate according to claim 1, further comprising:
a second covered insulating layer disposed on a second surface side of the glass substrate so as to cover at least a boundary between the through electrode and the glass substrate, and including a third through hole connected to the through hole; and
a third via disposed in the third through hole of the second covered insulating layer, and electrically connected to the through electrode.

6. A through electrode substrate comprising:
the through electrode substrate intermediate according to any one of claim 1 to claim 5; and
a bellows wiring layer disposed on an elastic insulating layer side surface of the through electrode substrate intermediate, including a bellows-shaped portion including a plurality of mountain portions and a plurality of valley portions, and electrically connecting the pad portion for a via and the pad portion for connecting a wiring board.

7. A through electrode substrate provided with an element comprising:
the through electrode substrate according to claim 6; and
an element mounted on the through electrode substrate.

8. A semiconductor device comprising:
the through electrode substrate provided with an element according to claim 7; and
a wiring board electrically connected to the pad portion for connecting a wiring board of the through electrode substrate.

9. A through electrode substrate comprising:
a glass substrate including a first surface and a second surface facing the first surface, and including a first through hole;
a through electrode disposed in the first through hole of the glass substrate;
a covered insulating layer disposed on a first surface side of the glass substrate so as to cover at least a boundary between the through electrode and the glass substrate, and including a second through hole connected to the first through hole;
a first via disposed in the second through hole of the covered insulating layer, and electrically connected to the through electrode;
an elastic insulating layer disposed on a surface of the covered insulating layer that is opposite to the glass substrate, and including a third through hole;
a second via disposed in the third through hole of the elastic insulating layer, and electrically connected to the first via; and
a pad portion for connecting a wiring board disposed on a surface of the elastic insulating layer that is opposite side to the covered insulating layer, electrically connected to the second via, and to be electrically connected to a wiring board.

10. The through electrode substrate according to claim 9, wherein the elastic insulating layer has a convexoconcave shape, including a plurality of convex portions and a plurality of concave portions, on a surface on a side of the pad portion for connecting a wiring board.

11. The through electrode substrate according to claim 9, wherein a cross-sectional shape of the second through hole, in a thickness direction of the covered insulating layer, is a reverse tapered shape.

12. The through electrode substrate according to claim 9, wherein a rim portion of an aperture of the second through hole, at a surface of the covered insulating layer that is opposite to the glass substrate, has a curved surface in a cross-sectional view in a thickness direction of the covered insulating layer.

13. The through electrode substrate according to claim 9, wherein the elastic insulating layer also serves as the covered insulating layer, and the second via also serves as the first via.

14. The through electrode substrate according to claim 9, further comprising a pad portion for connecting an element disposed on a second surface side of the glass substrate, electrically connected to the through electrode, and to be electrically connected to an element.

15. The through electrode substrate according to claim 9, further comprising:
a second covered insulating layer disposed on a second surface side of the glass substrate so as to cover at least a boundary between the through electrode and the glass substrate, and including a fourth through hole connected to the first through hole; and
a third via disposed in the fourth through hole of the second covered insulating layer, and electrically connected to the through electrode.

16. A through electrode substrate provided with an element comprising:
the through electrode substrate according to any one of claim 9 to claim 15; and
an element mounted on the through electrode substrate.

17. A semiconductor device comprising:
the through electrode substrate provided with an element according to claim 16; and
a wiring board electrically connected to the pad portion for connecting a wiring board of the through electrode substrate.
